# EUROPEAN PATENT APPLICATION

(11) **EP 4 567 873 A1**
(43) Date of publication of application: **11.06.2025**
(21) Application number: 24208004.2
(22) Date of filing: 22.10.2024
(51) Int. Cl.: H01L 21/768, H01L 23/528, H01L 23/485, H01L 23/48

(54) **CONDUCTIVE VIA WITH FRONT-SIDE AND BACK-SIDE CONNECTIONS WITH A SOURCE OR DRAIN REGION**

(30) Priority: 06.12.2023 US 202318530689
(71) Applicant: INTEL Corporation, Santa Clara, CA 95054 (US)
(72) Inventor: Hung, Ting-Hsiang, Beaverton, OR 97007 (US); Zhang, Yang, Rio Rancho, NM 87124 (US); Chao, Robin, Portland, OR 97209 (US); Xu, Guowei, Portland, OR 97229 (US); Chu, Tao, Portland, OR 97229 (US); Huang, Chiao-Ti, Portland, OR 97229 (US); Zhang, Feng, Hillsboro, OR 97123 (US); Lin, Chia-Ching, Portland, OR 97229 (US); Zhang, Kan, Hillsboro, OR 97123 (US); Murthy, Anand S., Portland, OR 97229 (US)
(74) Representative: Goddar, Heinz J.

(57) **Abstract**

A fabrication method and associated integrated circuit (IC) structures and devices that include a conductive via with front-side and back-side connections with an S/D region are described herein. In one example, an IC structure includes a conductive via extending between a first layer and a second layer and an S/D region of a transistor between the first layer and the second layer, where the S/D region includes a first semiconductor material and a second semiconductor material. In one such example, the second semiconductor material may be epitaxially grown on the first semiconductor material of the S/D region from a back side of the IC structure. Conductive elements in layers over and under the conductive via may couple the conductive via with the S/D region from both the front-side and back-side S/D contact structures.

## Description

### Background

For the past several decades, the scaling of features in integrated circuits (ICs) has been a driving force behind an ever-growing semiconductor industry. Scaling to smaller and smaller features enables increased densities of functional units on the limited real estate of semiconductor chips. For example, shrinking transistor size allows for the incorporation of an increased number of memory or logic devices on a chip, lending to the fabrication of products with increased capacity. The drive for the ever-increasing capacity, however, is not without issue. The necessity to optimize fabrication and performance of each component (e.g., the conductive interconnects for signaling, power delivery, and ground) is becoming increasingly significant.

### Brief Description of the Drawings

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.
FIG. 1 provides a perspective view of an example nanoribbon field-effect transistor (FET), according to one embodiment of the present disclosure.
FIG. 2 is a top-down view of an IC device including a conductive via with front-side and back-side connections with an S/D region, according to one embodiment of the present disclosure.
FIG. 3 is a flow diagram of an example method for fabricating an IC structure that includes a conductive via with front-side and back-side connections with an S/D region, in accordance with some embodiments.
FIGS. 4-10 provide cross-sectional side views at various stages in the fabrication of an example IC structure according to the method of FIG. 3, in accordance with some embodiments.
FIG. 11 is a top view of a wafer and dies that may include any of the IC devices disclosed herein, in accordance with any of the embodiments disclosed herein.
FIG. 12 is a side, cross-sectional view of an IC package that may include any of the IC devices disclosed herein, in accordance with various embodiments.
FIG. 13 is a side, cross-sectional view of an IC device assembly that may include any of the IC devices disclosed herein, in accordance with any of the embodiments disclosed herein.
FIG. 14 is a block diagram of an example electrical device that may include any of the IC devices disclosed herein, in accordance with any of the embodiments disclosed herein.

### Detailed Description

Disclosed herein are integrated circuit (IC) structures and devices including a conductive via coupled with a source region or a drain region (referred to herein as an "S/D region") with front-side and back-side contacts. The systems, methods and devices of this disclosure each have several innovative aspects, no single one of which is solely responsible for all desirable attributes disclosed herein. Details of one or more implementations of the subject matter described in this specification are set forth in the description below and the accompanying drawings.

As IC structures become more compact with smaller feature sizes and higher device density, new challenges arise in the fabrication processes of such devices. For example, in some IC structures, conductive vias are placed in a device region between conductive peripherals (such as conductive gates or S/D regions of transistors). The conductive via may be coupled to an adjacent device with one or more conductive interconnects, such as metal lines, over the device region. For example, a conductive via for power delivery may be coupled to a source region of a transistor with a metal line in an interconnect layer over the conductive via and over a source contract structure. The contact area between the metal line and the conductive via can affect the resistance of the conductive via. For example, a smaller contact area between the metal line and the conductive via (e.g., due to a small via width and/or due to a partially misaligned landing of the metal line on the conductive via) may result in higher resistance in the conductive via, which can negatively impact device performance.

In accordance with embodiments described herein, connecting a conductive via with an adjacent S/D region with both a front-side contact and a back-side S/D contact structure may enable increased contact area, resulting in lower via resistance and improved device performance. In one example, an IC structure includes a conductive via extending between a first layer and a second layer and an S/D region of a transistor between the first layer and the second layer, where the S/D region includes a first semiconductor material (e.g., in a portion of the S/D region closer to a front side of the IC structure) and a second semiconductor material (e.g., in a portion of the S/D region closer to a back side of the IC structure). In one such example, the second semiconductor material may be epitaxially grown on the first semiconductor material of the S/D region from the back side of the IC structure. Conductive elements in layers over and under the conductive via may couple the conductive via with the S/D region from both front-side and back-side S/D contact structures. For example, a conductive via may be coupled with the first semiconductor material of the S/D region with a front-side contact structure, and coupled with the second semiconductor material of the S/D region with a back-side contact structure. Connecting the conductive via with the S/D region from a front side and a back side can enable an additional current path and increased contact area, which may reduce resistance in the conductive via and improve device performance. In one example, epitaxially growing a second semiconductor material at a bottom of an S/D region from a back side of the IC structure may improve the back-side connection between the S/D region and the conductive via. Additionally, an epitaxially grown second semiconductor material may improve yield by filling in gaps that may exist due to defects and/or as a side effect from one or more processes.

While some descriptions are provided herein with respect to the use of vias (e.g., deep trench vias) for backside power delivery, embodiments of the present disclosure are equally applicable to using vias for back-side signal or ground delivery, as well as to vias being used for purposes of delivering power, signal, or ground to IC components from the front side.

IC structures as described herein, in particular IC structures including a conductive via having front-side and back-side connections with an S/D region, may be implemented in one or more components associated with an IC or/and between various such components. In various embodiments, components associated with an IC include, for example, transistors, diodes, power sources, resistors, capacitors, inductors, sensors, transceivers, receivers, antennas, etc. Components associated with an IC may include those that are mounted on an IC or those connected to an IC. The IC may be either analog or digital and may be used in a number of applications, such as microprocessors, optoelectronics, logic blocks, audio amplifiers, etc., depending on the components associated with the IC. In some embodiments, IC structures as described herein may be included in a radio frequency IC (RFIC), which may, e.g., be included in any component associated with an IC of a radio frequency (RF) receiver, an RF transmitter, or an RF transceiver, e.g., as used in telecommunications within base stations (BS) or user equipment (UE). Such components may include, but are not limited to, power amplifiers, low-noise amplifiers, RF filters (including arrays of RF filters, or RF filter banks), switches, upconverters, downconverters, and duplexers. In some embodiments, IC structures as described herein may be included in memory devices or circuits. In some embodiments, IC structures as described herein may be employed as part of a chipset for executing one or more related functions in a computer.

For purposes of explanation, specific numbers, materials and configurations are set forth in order to provide a thorough understanding of the illustrative implementations. However, it will be apparent to one skilled in the art that the present disclosure may be practiced without the specific details or/and that the present disclosure may be practiced with only some of the described aspects. In other instances, well-known features are omitted or simplified in order not to obscure the illustrative implementations. The terms "substantially," "close," "approximately," "near," and "about," generally refer to being within +/-10% of a target value, e.g., within +/- 5% of a target value, based on the context of a particular value as described herein or as known in the art. Similarly, terms indicating orientation of various elements, e.g., "coplanar," "perpendicular," "orthogonal," "parallel," or any other angle between the elements, generally refer to being within +/-10% of a target value, e.g., within +/- 5% of a target value, based on the context of a particular value as described herein or as known in the art.

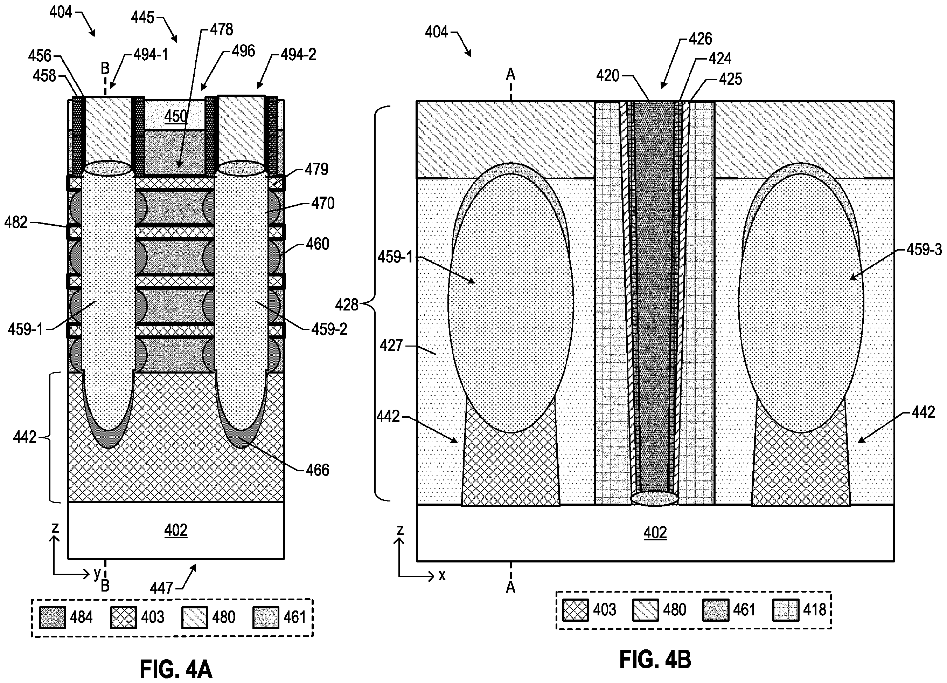

In the following description, references are made to the accompanying drawings that form a part hereof, and in which is shown, by way of illustration, embodiments that may be practiced. It is to be understood that other embodiments may be utilized, and structural or logical changes may be made without departing from the scope of the present disclosure. Therefore, the following detailed description is not to be taken in a limiting sense. For convenience, if a collection of drawings designated with different letters are present, e.g., FIGS. 4A-4B, such a collection may be referred to herein without the letters, e.g., as "FIG. 4."

In the drawings, while some schematic illustrations of example structures of various devices and assemblies described herein may be shown with precise right angles and straight lines, this is simply for ease of illustration, and embodiments of these assemblies may be curved, rounded, or otherwise irregularly shaped as dictated by, and sometimes inevitable due to, the fabricating processes used to fabricate semiconductor device assemblies. Therefore, it is to be understood that such schematic illustrations may not reflect real-life process limitations which may cause the features to not look so "ideal" when any of the structures described herein are examined using e.g., scanning electron microscopy (SEM) images or transmission electron microscope (TEM) images. In such images of real structures, possible processing defects could also be visible, e.g., not-perfectly straight edges of materials, tapered vias or other openings, inadvertent rounding of corners or variations in thicknesses of different material layers, occasional screw, edge, or combination dislocations within the crystalline region, and/or occasional dislocation defects of single atoms or clusters of atoms. There may be other defects not listed here but that are common within the field of device fabrication. Inspection of layout and mask data and reverse engineering of parts of a device to reconstruct the circuit using e.g., optical microscopy, TEM, or SEM, and/or inspection of a cross-section of a device to detect the shape and the location of various device elements described herein using, e.g., Physical Failure Analysis (PFA) would allow determination of the presence of IC structures that include a conductive via having front-side and back-side connections with an S/D region.

Various aspects of the illustrative implementations will be described using terms commonly employed by those skilled in the art to convey the substance of their work to others skilled in the art. For example, the terms "oxide," "carbide," "nitride," "silicide," etc. refer to compounds containing, respectively, oxygen, carbon, nitrogen, silicon, etc.; the term "high-k dielectric" refers to a material having a higher dielectric constant than silicon oxide; the term "low-k dielectric" refers to a material having a lower dielectric constant than silicon oxide. Materials referred to herein with formulas or as compounds cover all materials that include elements of the formula or a compound, e.g., TiSi or titanium silicide may refer to any material that includes titanium and silicon, WN or tungsten nitride may refer to any material that includes tungsten and nitrogen, etc. The term "insulating" means "electrically insulating," the term "conducting" means "electrically conducting," unless otherwise specified. Furthermore, the term "connected" may be used to describe a direct electrical or magnetic connection between the things that are connected, without any intermediary devices, while the term "coupled" may be used to describe either a direct electrical or magnetic connection between the things that are connected, or an indirect connection through one or more passive or active intermediary devices. A first component described to be electrically coupled to a second component means that the first component is in conductive contact with the second component (i.e., that a conductive pathway is provided to route electrical signals/power between the first and second components).

Various operations may be described as multiple discrete actions or operations in turn, in a manner that is most helpful in understanding the claimed subject matter. However, the order of description should not be construed as to imply that these operations are necessarily order dependent. These operations may not be performed in the order of presentation. Operations described may be performed in a different order from the described embodiment. Various additional operations may be performed, and/or described operations may be omitted in additional embodiments.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). The term "between," when used with reference to measurement ranges, is inclusive of the ends of the measurement ranges.

The description uses the phrases "in an embodiment" or "in embodiments," which may each refer to one or more of the same or different embodiments. The terms "comprising," "including," "having," and the like, as used with respect to embodiments of the present disclosure, are synonymous. The disclosure may use perspective-based descriptions such as "above," "below," "top," "bottom," and "side"; such descriptions are used to facilitate the discussion and are not intended to restrict the application of disclosed embodiments. The accompanying drawings are not necessarily drawn to scale. Unless otherwise specified, the use of the ordinal adjectives "first," "second," and "third," etc., to describe a common object, merely indicate that different instances of like objects are being referred to and are not intended to imply that the objects so described must be in a given sequence, either temporally, spatially, in ranking or in any other manner. Although some materials may be described in singular form, such materials may include a plurality of materials, e.g., a semiconductor material may include two or more different semiconductor materials.

IC structures including a conductive via having front-side and back-side connections with an S/D region may also include transistors of any architecture, such as any non-planar or planar architecture. Non-planar transistors such as double-gate transistors, tri-gate transistors, FinFETs, and nanowire/nanoribbon/nanosheet transistors refer to transistors having a non-planar architecture. In comparison to a planar architecture where the transistor channel has only one confinement surface, a non-planar architecture is any type of architecture where the transistor channel has more than one confinement surface. A confinement surface refers to a particular orientation of the channel surface that is confined by the gate field. Non-planar transistors potentially improve performance relative to transistors having a planar architecture, such as single-gate transistors.

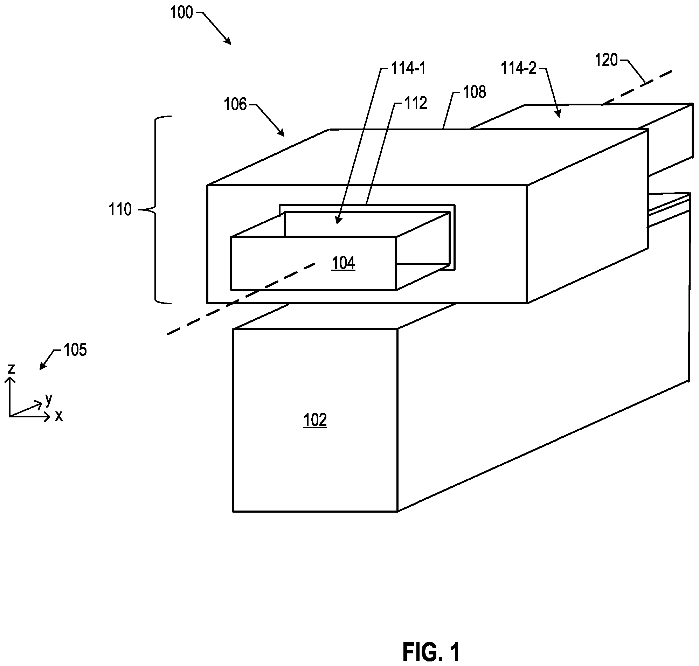

Nanoribbon transistors may be particularly advantageous for continued scaling of complementary metal-oxide-semiconductor (CMOS) technology nodes due to the potential to form gates on all four sides of a channel material (hence, such transistors are sometimes referred to as "gate all around" transistors). Therefore, some IC structures illustrated herein show nanoribbon transistors as an example (e.g., IC structures shown in FIG. 1, FIG. 2, and FIGS. 4-10), although IC structures that include a conductive via with front-side and back-side connections with an S/D region as described herein may include other devices instead of or in addition to nanoribbon transistors, and are not limited to such transistors.

As used herein, the term "nanoribbon" refers to an elongated structure of a semiconductor material having a longitudinal axis parallel to a support structure (e.g., a substrate, a die, a chip, or a wafer) over which such a structure is built. Typically, a length of a such a structure (i.e., a dimension measured along the longitudinal axis, shown in the present drawings to be along the y-axis of an example x-y-z coordinate system 105 shown in FIG. 1) is greater than each of a width (i.e., a dimension measured along the x-axis of the coordinate system 105) and a thickness/height (i.e., a dimension measured along the z-axis of the coordinate system 105). In some settings, the terms "nanoribbon" or "nanosheet" have been used to describe elongated semiconductor structures that have a rectangular transverse cross-section (i.e., a cross-section in a plane perpendicular to the longitudinal axis of the structure), while the term "nanowire" has been used to describe similar elongated structures but with circular transverse cross-sections. In the present disclosure, the term "nanoribbon" is used to refer to all such nanowires, nanoribbons, and nanosheets, as well as elongated semiconductor structures with a longitudinal axis parallel to the support structures and with having transverse cross-sections of any geometry (e.g., transverse cross-sections in the shape of an oval or a polygon with rounded corners). A transistor may then be described as a "nanoribbon transistor" if the channel of the transistor is a portion of a nanoribbon, i.e., a portion around which a gate stack of a transistor may wrap around. The semiconductor material in the portion of the nanoribbon that forms a channel of a transistor may be referred to as a "channel material," with source and drain regions of a transistor provided on either side of the channel material.

FIG. 1 provides a perspective view of an example IC structure 100 with a nanoribbon transistor 110, according to some embodiments of the present disclosure. As shown in FIG. 1, the IC structure 100 includes a semiconductor material formed as a nanoribbon 104 extending substantially parallel to a support 102. The transistor 110 may be formed on the basis of the nanoribbon 104 by having a gate stack 106 wrap around at least a portion of the nanoribbon referred to as a "channel portion" and by having source and drain regions, shown in FIG. 1 as a first S/D region 114-1 and a second S/D region 114-2, on either side of the gate stack 106. One of the S/D regions 114 is a source region and the other one is a drain region. However, because, as is common in the field of FETs, designations of source and drain are often interchangeable, they are simply referred to herein as a first S/D region 114-1 and a second S/D region 114-2.

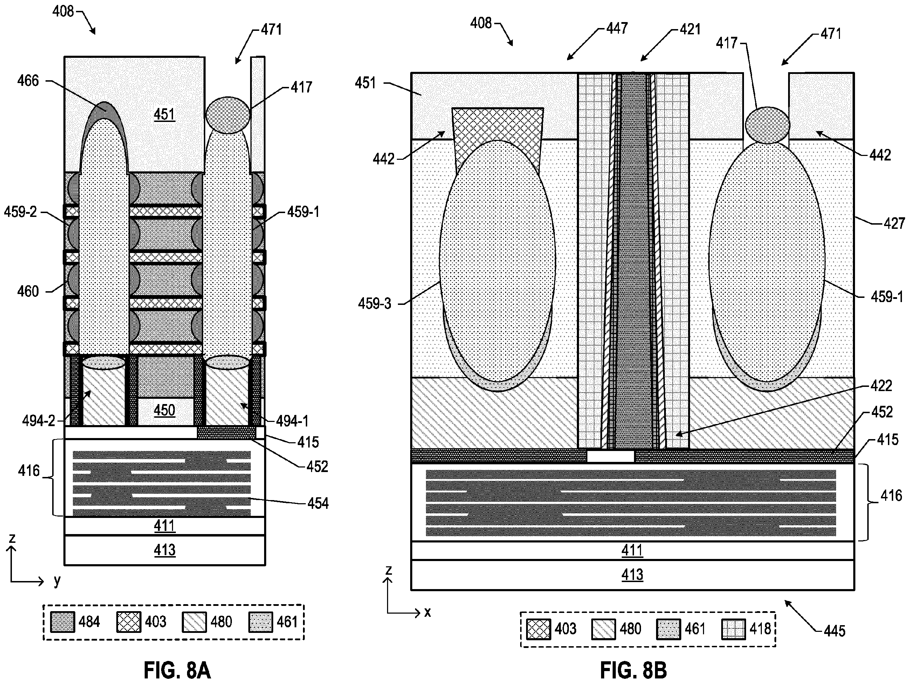

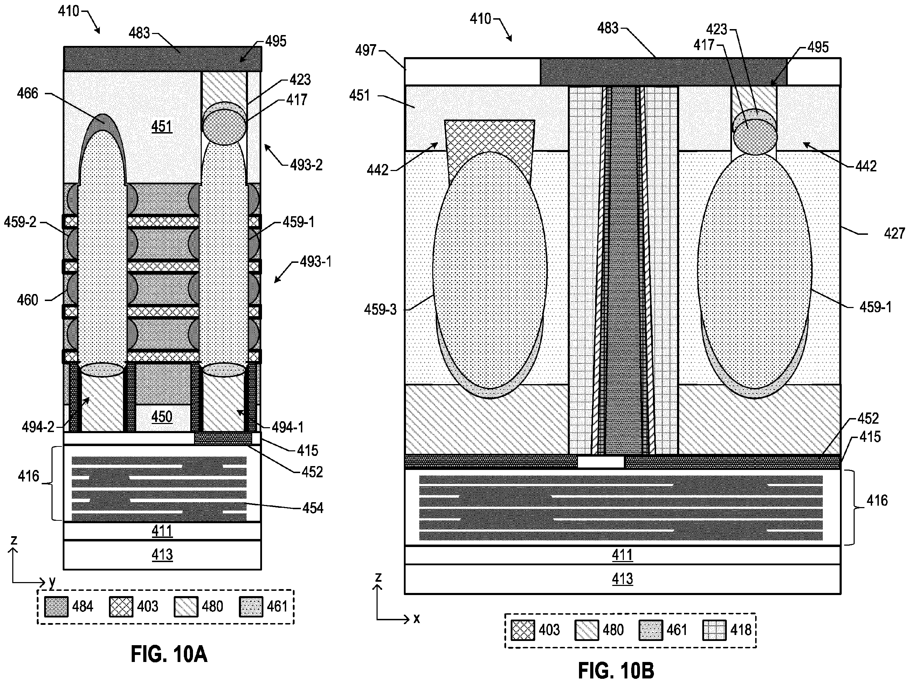

Implementations of the present disclosure may be formed or carried out on any suitable support 102, such as a substrate, a die, a wafer, or a chip. The support 102 may, e.g., be the wafer 1500 of FIG. 8, discussed below, and may be, or be included in, a die, e.g., the singulated die 1502 of FIG. 8, discussed below. The support 102 may be a semiconductor substrate composed of semiconductor material systems including, for example, N-type or P-type materials systems. In one implementation, the semiconductor substrate may be a crystalline substrate formed using a bulk silicon or a silicon-on-insulator (SOI) substructure. In other implementations, the semiconductor substrate may be formed using alternate materials, which may or may not be combined with silicon, that include, but are not limited to, germanium, silicon germanium, indium antimonide, lead telluride, indium arsenide, indium phosphide, gallium arsenide, aluminum gallium arsenide, aluminum arsenide, indium aluminum arsenide, aluminum indium antimonide, indium gallium arsenide, gallium nitride, indium gallium nitride, aluminum indium nitride or gallium antimonide, or other combinations of group III-V materials (i.e., materials from groups III and V of the periodic system of elements), group II-VI (i.e., materials from groups II and IV of the periodic system of elements), or group IV materials (i.e., materials from group IV of the periodic system of elements). In some embodiments, the substrate may be non-crystalline. In some embodiments, the support 102 may be a printed circuit board (PCB) substrate, a package substrate, an interposer, a wafer, or a die. Although a few examples of materials from which the support 102 may be formed are described here, any material that may serve as a foundation upon which an IC structure including a conductive via having front-side and back-side connections with an S/D region as described herein may be built falls within the spirit and scope of the present disclosure. Although only one nanoribbon 104 is shown in FIG. 1, the IC structure 100 may include a stack of such nanoribbons where a plurality of nanoribbons 104 are stacked above one another. For example, FIG. 10 shows an IC structure that may be an example of the IC structure 100. In some embodiments, a portion of the support 102 right below the lowest nanoribbon 104 of the stack may be shaped as a subfin extending away from a base, as is known in the field of nanoribbon transistors.

The nanoribbon 104 may take the form of a nanowire or nanoribbon, for example. In some embodiments, an area of a transversal cross-section of the nanoribbon 104 (i.e., an area in the x-z plane of an x-y-z coordinate system 105 shown in FIG. 1, perpendicular to a longitudinal axis 120 of the nanoribbon 104) may be between about 25 and 10000 square nanometers, including all values and ranges therein (e.g., between about 25 and 1000 square nanometers, or between about 25 and 500 square nanometers). In some embodiments, a width of the nanoribbon 104 (i.e., a dimension measured in a plane parallel to the support 102 and in a direction perpendicular to the longitudinal axis 120 of the nanoribbon 104, e.g., along the x-axis of the coordinate system 105) may be at least about 3 times larger than a height of the nanoribbon 104 (i.e., a dimension measured in a plane perpendicular to the support 102, e.g., along the z-axis of the coordinate system 105), including all values and ranges therein, e.g., at least about 4 times larger, or at least about 5 times larger. Although the nanoribbon 104 illustrated in FIG. 1 is shown as having a rectangular cross-section, the nanoribbon 104 may instead have a cross-section that is rounded at corners or otherwise irregularly shaped, and the gate stack 106 may conform to the shape of the nanoribbon 104. The term "face" of a nanoribbon may refer to the side of the nanoribbon 104 that is larger than the side perpendicular to it (when measured in a plane substantially perpendicular to the longitudinal axis 120 of the nanoribbon 104), the latter side being referred to as a "sidewall" of a nanoribbon.

In various embodiments, the semiconductor material of the nanoribbon 104 may be composed of semiconductor material systems including, for example, N-type or P-type materials systems. In some embodiments, the nanoribbon 104 may include a high mobility oxide semiconductor material, such as tin oxide, antimony oxide, indium oxide, indium tin oxide, titanium oxide, zinc oxide, indium zinc oxide, gallium oxide, titanium oxynitride, ruthenium oxide, or tungsten oxide. In some embodiments, the nanoribbon 104 may include a combination of semiconductor materials. In some embodiments, the nanoribbon 104 may include a monocrystalline semiconductor, such as silicon (Si) or germanium (Ge). In some embodiments, the nanoribbon 104 may include a compound semiconductor with a first sub-lattice of at least one element from group III of the periodic table (e.g., Al, Ga, In), and a second sub-lattice of at least one element of group V of the periodic table (e.g., P, As, Sb).

For some example N-type transistor embodiments (i.e., for the embodiments where the transistor 110 is an N-type metal-oxide-semiconductor (NMOS) transistor), the channel material of the nanoribbon 104 may include a III-V material having a relatively high electron mobility, such as, but not limited to InGaAs, InP, InSb, and InAs. For some such embodiments, the channel material of the nanoribbon 104 may be a ternary III-V alloy, such as InGaAs, GaAsSb, InAsP, or InPSb. For some InₓGa₁₋ₓAs fin embodiments, In content (x) may be between 0.6 and 0.9, and may advantageously be at least 0.7 (e.g., In_{0.7}Ga_{0.3}As). For some example P-type transistor embodiments (i.e., for the embodiments where the transistor 110 is a P-type metal-oxide-semiconductor (PMOS) transistor), the channel material of the nanoribbon 104 may advantageously be a group IV material having a high hole mobility, such as, but not limited to Ge or a Ge-rich SiGe alloy. For some example embodiments, the channel material of the nanoribbon 104 may have a Ge content between 0.6 and 0.9, and advantageously may be at least 0.7.

In some embodiments, the channel material of the nanoribbon 104 may be a thin-film material, such as a high mobility oxide semiconductor material, such as tin oxide, antimony oxide, indium oxide, indium tin oxide, titanium oxide, zinc oxide, indium zinc oxide, indium gallium zinc oxide (IGZO), gallium oxide, titanium oxynitride, ruthenium oxide, or tungsten oxide. In general, if the transistor formed in the nanoribbon is a thin-film transistor (TFT), the channel material of the nanoribbon 104 may include one or more of tin oxide, cobalt oxide, copper oxide, antimony oxide, ruthenium oxide, tungsten oxide, zinc oxide, gallium oxide, titanium oxide, indium oxide, titanium oxynitride, indium tin oxide, indium zinc oxide, nickel oxide, niobium oxide, copper peroxide, IGZO, indium telluride, molybdenite, molybdenum diselenide, tungsten diselenide, tungsten disulfide, Nor P-type amorphous or polycrystalline silicon, germanium, indium gallium arsenide, silicon germanium, gallium nitride, aluminum gallium nitride, indium phosphite, and black phosphorus, each of which may possibly be doped with one or more of gallium, indium, aluminum, fluorine, boron, phosphorus, arsenic, nitrogen, tantalum, tungsten, and magnesium, etc. In some embodiments, the channel material of the nanoribbon 104 may have a thickness between about 5 and 75 nanometers, including all values and ranges therein. In some embodiments, a thin-film channel material may be deposited at relatively low temperatures, which allows depositing the channel material within the thermal budgets imposed on back-end fabrication to avoid damaging other components, e.g., front-end components such as the logic devices.

A gate stack 106 including a gate electrode material 108 and, optionally, a gate insulator material 112, may wrap entirely or almost entirely around a portion of the nanoribbon 104 as shown in FIG. 1, with the active region (channel region) of the channel material of the transistor 110 corresponding to the portion of the nanoribbon 104 wrapped by the gate stack 106. As shown in FIG. 1, the gate insulator material 112 may wrap around a transversal portion of the nanoribbon 104 and the gate electrode material 108 may wrap around the gate insulator material 112.

The gate electrode material 108 may include one or more gate electrode materials, where the choice of the gate electrode materials may depend on whether the transistor 110 is a PMOS transistor or an NMOS transistor. For a PMOS transistor, gate electrode materials that may be used in different portions of the gate electrode material 108 may include, but are not limited to, ruthenium, palladium, platinum, cobalt, nickel, and conductive metal oxides (e.g., ruthenium oxide). For an NMOS transistor, gate electrode materials that may be used in different portions of the gate electrode material 108 include, but are not limited to, hafnium, zirconium, titanium, tantalum, aluminum, alloys of these metals, and carbides of these metals (e.g., hafnium carbide, zirconium carbide, titanium carbide, tantalum carbide, and aluminum carbide). In some embodiments, the gate electrode material 108 may include a stack of a plurality of gate electrode materials, where zero or more materials of the stack are workfunction (WF) materials and at least one material of the stack is a fill metal layer. Further materials/layers may be included next to the gate electrode material 108 for other purposes, such as to act as a diffusion barrier layer or/and an adhesion layer.

In some embodiments, the gate insulator material 112 may include one or more high-k dielectrics including any of the materials discussed herein with reference to the insulator material that may surround portions of the transistor 110. In some embodiments, an annealing process may be carried out on the gate insulator material 112 during fabrication of the transistor 110 to improve the quality of the gate insulator material 112. The gate insulator material 112 may have a thickness that may, in some embodiments, be between about 0.5 nanometers and 3 nanometers, including all values and ranges therein (e.g., between about 1 and 3 nanometers, or between about 1 and 2 nanometers). In some embodiments, the gate stack 106 may be surrounded by a gate spacer, not shown in FIG. 1. Such a gate spacer would be configured to provide separation between the gate stack 106 and S/D contacts of the transistor 110 and could be made of a low-k dielectric material, some examples of which have been provided above.

Turning to the S/D regions 114 of the transistor 110, in some embodiments, the S/D regions may be highly doped, e.g., with dopant concentrations of about 10²¹ cm³, in order to advantageously form Ohmic contacts with the respective S/D contacts (not shown in FIG. 1), although these regions may also have lower dopant concentrations and may form Schottky contacts in some implementations. Irrespective of the exact doping levels, the S/D regions of a transistor are the regions having dopant concentration higher than in other regions, e.g., higher than a dopant concentration in the transistor channel (i.e., in a channel material extending between the first S/D region 114-1 and the second S/D region 114-2), and, therefore, may be referred to as "highly doped" (HD) regions. Even when doped to realize threshold voltage tuning as described herein, the channel portions of transistors typically include semiconductor materials with doping concentrations significantly smaller than those of the S/D regions 114.

The S/D regions 114 of the transistor 110 may generally be formed using either an implantation/diffusion process or an etching/deposition process. In the former process, dopants such as boron, aluminum, antimony, phosphorous, or arsenic may be ion-implanted into the nanoribbon 104 to form the source and drain regions. An annealing process that activates the dopants and causes them to diffuse further into the nanoribbon 104 may follow the ion implantation process. In the latter process, portions of the nanoribbon 104 may first be etched to form recesses at the locations of the future S/D regions 114. An epitaxial deposition process may then be carried out to fill the recesses with material that is used to fabricate the S/D regions 114. In some implementations, the S/D regions 114 may be fabricated using a silicon alloy such as silicon germanium or silicon carbide. In some implementations, the epitaxially deposited silicon alloy may be doped in situ with dopants such as boron, arsenic, or phosphorous. In further embodiments, the S/D regions 114 may be formed using one or more alternate semiconductor materials such as germanium or a group III-V material or alloy. And in further embodiments, one or more layers of metal and/or metal alloys may be used to form the S/D regions 114. In some embodiments, a distance between the first and second S/D regions 114 (i.e., a dimension measured along the longitudinal axis 120 of the nanoribbon 104) may be between about 5 and 40 nanometers, including all values and ranges therein (e.g., between about 22 and 35 nanometers, or between about 20 and 30 nanometers).

The IC structure 100 shown in FIG. 1, as well as IC structures shown in other drawings of the present disclosure, is intended to show relative arrangements of some of the components therein, and the IC structure 100, or portions thereof, may include other components that are not illustrated (e.g., electrical contacts to the S/D regions 114 of the transistor 110, additional layers such as a spacer layer around the gate electrode of the transistor 110, etc.). For example, although not specifically illustrated in FIG. 1, a dielectric spacer may be provided between a first S/D contact (which may also be referred to as a "first S/D electrode") coupled to a first S/D region 114-1 of the transistor 110 and the gate stack 106 as well as between a second S/D contact (which may also be referred to as a "second S/D electrode") coupled to a second S/D region 114-2 of the transistor 110 and the gate stack 106 in order to provide electrical isolation between the source, gate, and drain electrodes. In another example, although not specifically illustrated in FIG. 1, at least portions of the transistor 110 may be surrounded in an insulator material, such as any suitable interlayer dielectric (ILD) material. In some embodiments, such an insulator material may be a high-k dielectric including elements such as hafnium, silicon, oxygen, titanium, tantalum, lanthanum, aluminum, zirconium, barium, strontium, yttrium, lead, scandium, niobium, and zinc. Examples of high-k materials that may be used for this purpose may include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, tantalum oxide, tantalum silicon oxide, lead scandium tantalum oxide, and lead zinc niobate. In other embodiments, the insulator material surrounding portions of the transistor 110 may be a low-k dielectric material. Some examples of low-k dielectric materials include, but are not limited to, silicon dioxide, carbon-doped oxide, silicon nitride, organic polymers such as perfluorocyclobutane or polytetrafluoroethylene, fused silica glass (FSG), and organosilicates such as silsesquioxane, siloxane, or organosilicate glass.

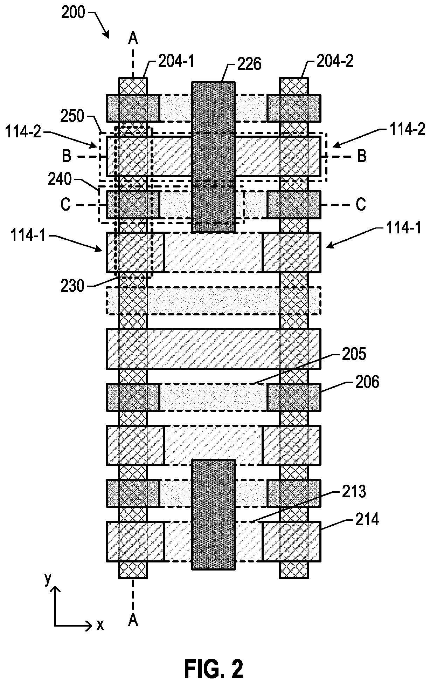

FIG. 2 is a top-down view of an IC structure 200 that may include a conductive via having front-side and back-side connections with an S/D region, according to one embodiment of the present disclosure. Some of the materials are not shown in the top-down view in order to not obscure the drawing.

As shown in FIG. 2, the IC structure 200 may include two nanoribbon stacks 204-1 and 204-2 (collectively referred to as "nanoribbon stacks 204"), if the transistors to be implemented in the IC structure 200 are nanoribbon transistors such as the one illustrated in FIG. 1. Alternatively, what is now shown as nanoribbon stacks 204-1 and 204-2 could be fins, if the transistors to be implemented in the IC structure 200 are FinFETs. The nanoribbon stacks 204 may include stacks of one or more nanoribbons 104 as described above and may be provided over a support such as the support 102 (not specifically shown in FIG. 2). The nanoribbon stacks 204 may extend substantially parallel to one another, e.g., along the y-axis of the coordinate system 105, consistent with the illustration of FIG. 1. Metal gate lines 205 (shown in FIG. 2 to be within dashed contours) and S/D contact lines 213 may extend substantially perpendicular to the nanoribbon stacks 204 and substantially parallel to one another, e.g., along the x-axis of the coordinate system 105. FIG. 2 illustrates that the metal gate lines 205 and the S/D contact lines 213 may be provided in an alternating manner. Metal gate lines 205 may be cut and removed where the deep trench vias are placed, so that gate contacts 206 effectively act as portions of the metal lines 205. In FIG. 2, portions of the metal gate lines 205 are shown with dashed contours, indicating that these are the portions where the metal gate lines 205 have been removed. The gate contacts 206 are in conductive contact with the gate stacks 106 (which are underneath the gate contacts 206 and, therefore, not seen in the view of FIG. 2) provided over channel portions of the nanoribbon stacks 204, providing electrical connectivity to the gates of the nanoribbon transistors. Thus, portions of the gate contacts 206 intersecting the gate stacks 106 are in conductive contact with the gate stacks 106 and serve as gate contacts for the transistors.

Similarly, S/D contact lines 213 may be cut and removed where the deep trench vias are placed, so that S/D contacts 214 effectively act as portions of the S/D contact lines 213. In FIG. 2, portions of the S/D contact lines 213 are shown with dashed contours, indicating that these are the portions where the S/D contact lines 213 have been removed. The S/D contacts 214 are provided over S/D regions 114 (which are underneath the S/D contacts 214 and, therefore, not seen in the view of FIG. 2) of the nanoribbon stacks 204, providing electrical connectivity to the S/D regions 114 of the nanoribbon transistors. Thus, portions of the S/D contacts 214 intersecting the S/D regions 114 are in conductive contact with the S/D regions 114 and serve as S/D contacts for the transistors.

FIG. 2 further illustrates that deep trench vias 226 may be provided in the vicinity of the transistors formed on the basis of the nanoribbon stacks 204. Two instances of the deep trench vias 226 are shown in FIG. 2, but, in other embodiments, any other number of one or more deep trench vias 226 may be included in the IC structure 200. Similarly, while a particular arrangement of gate stacks 106, metal gate lines 205, gate contacts 206, S/D contact lines 213, and S/D contacts 214 is shown in FIG. 1 and FIG. 2, in other embodiments, these elements may be arranged differently within the IC structure 200. In order to further illustrate details of the IC structure 200, FIG. 2 shows a portion 230 (illustrated with a dotted contour), a portion 240 (illustrated with a dot-dashed contour), and a portion 250 (illustrated with a double-dot-dashed contour). The portion 230 indicates an approximate outline of an example transistor such as the transistor 110, provided over the nanoribbon stack 204-1. The portion 240 illustrates a portion of the IC structure 200 with a gate contact 496 provided over a gate stack 106 over a channel portion of the nanoribbon stack 204-1 and a deep trench via 226. FIGS. 4A-4B, which are discussed below, are cross-sectional side views along different cross-sections of an example IC structure, such as cross-sectional views of the portions 230 and 250 of FIG. 2.

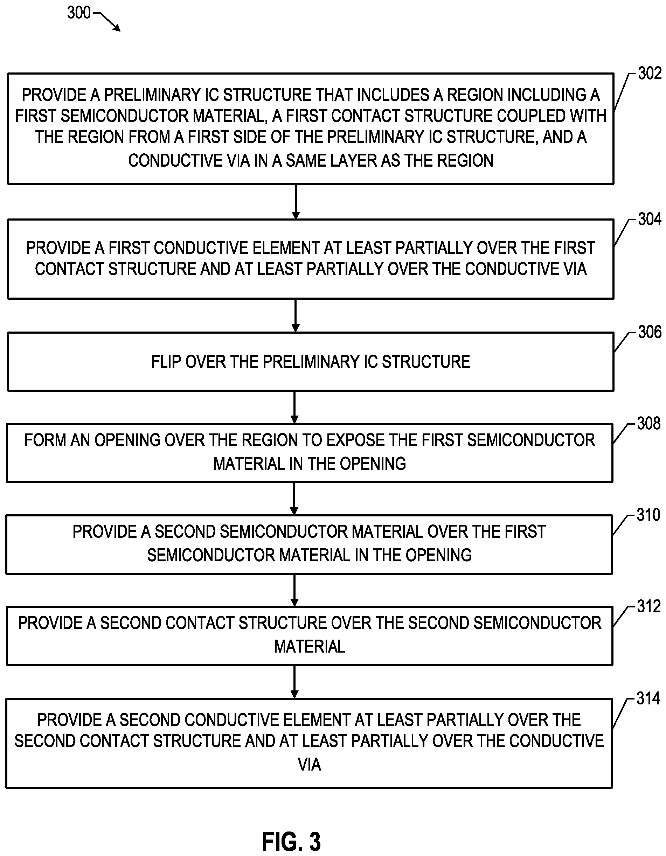

FIG. 3 is a flow diagram of an example method for fabricating an IC structure that includes a conductive via having front-side and back-side connections with an S/D region, in accordance with some embodiments. Although the operations of the method of FIG. 3 are illustrated once each and in a particular order, the operations may be performed in any suitable order and repeated as desired. For example, one or more operations may be performed in parallel to fabricate multiple IC structures with a conductive via having front-side and back-side connections with an S/D region substantially simultaneously. In another example, the operations may be performed in a different order to reflect the structure of an IC device in which a conductive via having front-side and back-side connections with an S/D region will be implemented.

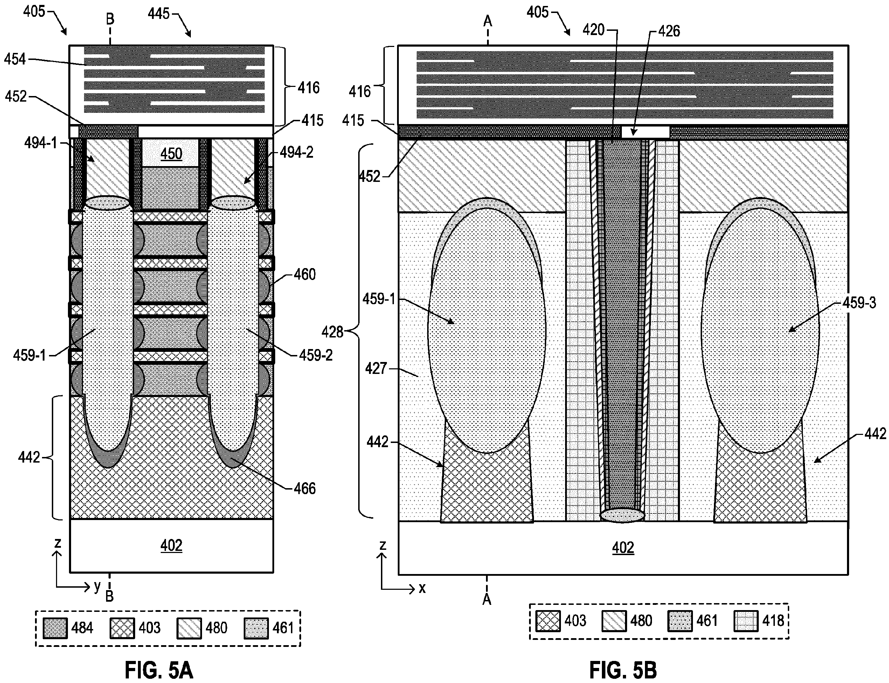

In addition, the example fabricating method of FIG. 3 may include other operations not specifically shown in FIG. 3, such as various cleaning or planarization operations as known in the art. For example, in some embodiments, a support, as well as layers of various other materials subsequently deposited thereon, may be cleaned prior to, after, or during any of the processes of the methods described herein, e.g., to remove oxides, surface-bound organic and metallic contaminants, as well as subsurface contamination. In some embodiments, cleaning may be carried out using e.g., a chemical solutions (such as peroxide), and/or with ultraviolet (UV) radiation combined with ozone, and/or oxidizing the surface (e.g., using thermal oxidation) then removing the oxide (e.g., using hydrofluoric acid (HF)). In another example, the intermediate IC structures described herein may be planarized prior to, after, or during any of the processes of the method of FIG. 5 described herein, e.g., to remove overburden or excess materials. In some embodiments, planarization may be carried out using either wet or dry planarization processes, e.g., planarization be a chemical mechanical planarization (CMP), which may be understood as a process that utilizes a polishing surface, an abrasive and a slurry to remove the overburden and planarize the surface.

FIGS. 4-10 provide cross-sectional side views at various stages in the fabrication of an example IC structure according to the method of FIG. 3, in accordance with some embodiments. FIGS. 4-10 each include two figures, labeled with letters A and B (e.g., FIG. 4 includes FIGS. 4A and 4B), providing different cross-sectional side views of a given IC structure. In particular, those figures of FIGS. 4-10 that are labeled with a letter A (e.g., FIG. 4A) illustrate cross-sections in the y-z plane of the example coordinate system shown in FIG. 1 along a plane AA shown in a corresponding figure labeled with a letter B (e.g., along a plane AA shown in FIG. 4B). Those figures of FIGS. 4-10 that are labeled with a letter B (e.g., FIG. 4B) illustrate cross-sections in the x-z plane of the example coordinate system shown in FIG. 1 along a plane BB shown in FIG. 4A. In order to not clutter the drawings, planes AA and BB may not be shown in some of FIGS. 4-10.

Turning to FIG. 3, the method 300 begins with a process 302 of providing a preliminary IC structure that includes a region including a first semiconductor material (e.g., an S/D region), a first contact structure coupled with the region from a first side, and a conductive via in a same layer as the S/D region. An IC structure 404 of FIGS. 4A-4B illustrates an example result of the process 302. As mentioned above, FIGS. 4A-4B illustrate cross-sectional side views along different cross-sections of the IC structure 404. In particular, FIG. 4A illustrates a cross-sectional side view of a portion of the IC structure 404 similar to the portion 230 along a plane AA shown in FIG. 2. FIG. 4B illustrates a cross-sectional side view of a portion of the IC structure similar to the portion 250 along a plane BB shown in FIG. 2. A number of elements referred to in the description of FIGS. 4-10 with reference numerals are illustrated in these drawings with different patterns, with a legend showing the correspondence between the reference numerals and patterns being provided at the bottom of each drawing page containing FIGS. 4-10. For example, the legend illustrates that FIGS. 4A-4B use different patterns to show a gate electrode material 484, a semiconductor material 403, an electrically conductive material 480 of an S/D contact, and so on.

As shown in FIG. 4A, the IC structure 404 includes a stack 478 of nanoribbons 479 over a support 402. The support may be an example of the support 102, and the nanoribbons 479 may be an example of the nanoribbon 104 of FIG. 1. In one example, the IC structure 404 includes a transistor similar to the transistor 110 but built on the basis of a stack 478 of a plurality of nanoribbons 479 instead of just one nanoribbon as shown in FIG. 1. While four nanoribbons 479 are shown to be included in the nanoribbon stack 478, in other embodiments, fewer nanoribbons or more nanoribbons may be included. FIG. 4A illustrates a semiconductor material 403 as the material of the nanoribbons 479, further illustrating a subfin 442 of the semiconductor material 403 below the nanoribbon stack 478, although in some embodiments the nanoribbons 479 and at least a portion of the subfin 442 may include semiconductor materials of different material compositions. As shown in FIG. 4A, a gate stack having a gate insulator material 482 and a gate electrode material 484 may wrap around channel portions of the nanoribbons 479. The gate insulator material 482 and the gate electrode material 484 may be the same as the gate insulator material 112 and the gate electrode material 108 of FIG. 1. In some examples, the gate insulator material 482 may be absent.

FIG. 4A further illustrates a first S/D region 459-1 and a second S/D region 459-2 extending through the nanoribbon stack 478, electrically insulated/separated from the gate electrode material 484 and from the semiconductor material 403 of the subfin 442 by an insulator material 466. In one example, the S/D regions 459 include a doped semiconductor material 470. In some embodiments, the insulator material 466 may form so-called "dimples" 460 in areas where the insulator material 466 separates the S/D regions 459 from the gate electrode material 484. The insulator material 466 may include any of the insulator materials described herein, e.g., any of the ILD materials described above.

Above the nanoribbon stack 478, FIG. 4A illustrates a gate contact 496 and S/D contact structures 494 on either side of the gate contact 496, individually labeled as a first S/D contact structure 494-1 for making electrical contact to the first S/D region 459-1 and a second S/D contact structure 494-2 for making electrical contact to the second S/D region 459-2. The S/D contact structures 494-1, 494-2 include an electrically conductive material 480. In the example illustrated in FIG. 4A, the S/D contact structures 494-1, 494-2 are coupled with the S/D regions 459-1, 459-2 at a first side 445 of the IC structure 404. The first side 445 may be referred to herein as a front side, which may also be a front side of a wafer or substrate in or on which the IC structure 404 is formed. Thus, the S/D contact structures 494-1, 494-2 may be referred to as "front-side contacts" or "front-side contact structures." The first side 445 is opposite a second side 447 of the IC structure 404. The second side 447 may be referred to herein as a back side, which may also be a back side of a wafer or substrate in or on which the IC structure 404 is formed. The gate contact 496 may include an electrically conductive material (not shown in FIG. 4A) in electrically conductive contact with the gate electrode material 484. In the perspective of the IC structure 404 shown in FIG. 4A, an insulator material 450 may insulate the gate electrode material 484 from other components in the IC structure 404, e.g., the S/D contact structures 494. The insulator material 450 may include any suitable insulator material, such as the insulator materials described above.

The S/D contact structures 494 may be electrically isolated from the gate electrode material 484 and the electrically conductive material of the gate contact 496 by gate spacers 458. The gate spacers 458 may include one or more of spacer materials, diffusion barrier materials, adhesion materials, etc., as known in the art for forming contacts to various components of IC structures. In some embodiments, the gate spacers 458 may include low-k dielectrics and/or any of the ILD materials described above. Optionally, sidewalls of the S/D contact structures 494 may be lined with one or more liners 456, where the liners 456 may include, but are not limited to, materials including silicon and nitrogen (e.g., silicon nitride), materials including silicon and oxygen (e.g., silicon oxide), materials including silicon and carbon (e.g., silicon carbide), and/or their composites. Within the sidewalls, the S/D contact structures 494 may be filled with an electrically conductive fill material 480. In various embodiments, material compositions of the electrically conductive fill material 480 and the electrically conductive material of the gate contact structure may be substantially the same (e.g., both may include/be tungsten) or different.

At the bottom of the S/D contact structures 494, an interface material 461 is deposited to provide an interface between the S/D regions 459 and the electrically conductive fill material 480 of S/D contact structures 494. The interface material 461 may include/be a metal such as titanium which, once deposited, may intermix with the material of the S/D regions 459, e.g., with silicon, forming a compound (e.g., titanium silicide) that may help reduce contact resistance of the S/D contact structures 494. Although FIG. 4A illustrates an example in which the interface material 461 is only present on the bottom of the S/D contact structures 494 and not the sidewalls of the S/D contact structures 494, in other examples the interface material 461 may be present on the bottom and sidewalls of the S/D contact structures 494. In other embodiments, the interface material 461 is optional and may be absent from the bottom and/or absent from the side walls of the S/D contact structures 494.

FIG. 4B provides another illustration of the IC structure 404 along the plane BB shown in FIG. 4A (i.e., a cut across S/D regions 459 of the nanoribbon stack 478 and another nanoribbon stack). FIG. 4B shows the plane AA along which the cut of FIG. 4A is shown. FIG. 4B illustrates a deep trench via 426, an insulator material 418 surrounding the deep trench via 426, a conductive via fill material 420, and two S/D regions 459-1, 459-3, one on each side of the deep trench via 426 and electrically insulated from the deep trench via 426 by the insulator material 418. The deep trench via 426 extends through one or more layers of a device region 428, where the device region 428 includes an active region of a device (e.g., a channel region and/or S/D regions of a device) such as the transistor shown in FIG. 4. Thus, the layers of the device region 428 include both the deep trench via 426 and the S/D regions 459. The two S/D regions 459-1, 459-3 shown in FIG. 4B are provided over different ones of the nanoribbon stacks, such as the stacks 204-1 and 204-2, as shown in FIG. 2. FIG. 4B further illustrates an insulator material 427 that may surround the S/D regions 459 below the electrically conductive fill material 480 of the S/D contact structures 494, and may also surround the sidewalls of the subfins 442 of the nanoribbon stacks. The insulator material 427 may, e.g., include any of the ILD materials described above and may have either substantially the same or different material compositions with any other insulator materials in the IC structure 404.

The electrically conductive via fill material 420 filling the deep trench via 426 may include any suitable conductive material, e.g., tungsten, and may have substantially the same or different material composition with the electrically conductive material of the gate contact 496 and/or with the electrically conductive fill material 480 of the S/D contact structures 494. FIG. 4B shows the interface material 461 on the S/D regions 459-1, 459-3 and at the bottom of the deep trench via 426, however, as mentioned above, an interface material may be present or absent at one or more of the bottom and/or sidewalls of the deep trench via 426 and the bottom and/or sidewalls of openings for the S/D contact structures 494. The deep trench via 426 may include one or more liners on sidewalls of the via 426. In the example illustrated in FIG. 4B, the IC structure 404 includes a first liner 425 and a second liner 424. The liners 424, 425 may include one or more of an insulator layer, a barrier layer, and/or adhesion layer. In one example, the first liner 425 includes an insulator material (e.g., a nitride, oxide, or other suitable insulator material), which may be the same as or different from the insulator material 418. In one example, the liner 424 may include TiN or another suitable material to form a diffusion barrier between the conductive via fill material 420 and the insulator material 418.

Thus, FIGS. 4A-4B illustrate a preliminary IC structure 404 that includes a region including a first semiconductor material (e.g., the S/D region 459-1 including the semiconductor material 470), a first contact structure (e.g., the contact structure 494-1) coupled with the region from a first side 445 of the IC structure 404, and a conductive via 426 in the same layer as the region (e.g., the conductive via 426 is in the same device region 428 layers as the S/D region 459-1).

Referring again to FIG. 3, the method 300 continues with the process 304 of providing a first conductive element at least partially over the first contact structure and at least partially over the conductive via. An IC structure 405 of FIGS. 5A-5B illustrates an example result of the process 304. As can be seen in FIGS. 5A-5B, the IC structure 405 includes the device region 428, a first interconnect layer 415 formed above the device region 428, and a second interconnect layer 416 formed above the first interconnect layer 415. Additional interconnect layers may be present above the second interconnect layer 416. A collection of interconnect layers such as the interconnect layers 415, 416, etc., may be referred to as a "metallization stack" of the IC structure 405. Interchangeably, the metallization stack may be referred to as the "back end of line (BEOL) layer(s)" of the IC structure 405, while the device region 428 may be referred to as the "front end of line (FEOL) layer(s)" of the IC structure 405.

Electrical signals, such as power and/or input/output (I/O) signals, may be routed to and/or from the devices (e.g., the transistors) of the device region 428 through one or more interconnect layers disposed on the device region 428 (illustrated in FIG. 5 as interconnect layers 415 and 416). For example, electrically conductive features of the device region 428 (e.g., the electrically conductive material 480 of the S/D contact structures 494 and the electrically conductive via fill material 420 of the deep trench via 426) may be electrically coupled with the interconnect structures 454 of the interconnect layers 415 and 416. The interconnect structures 454 may be arranged within the interconnect layers of the metallization stack to route electrical signals according to a wide variety of designs (in particular, the arrangement is not limited to the particular configuration of interconnect structures 454 depicted in FIG. 5). Although a particular number of interconnect layers 415 and 416 is depicted in FIG. 5, embodiments of the present disclosure include IC structures having more or fewer interconnect layers than depicted.

In some embodiments, the interconnect structures 454 may include conductive lines and/or conductive vias filled with an electrically conductive material such as a metal. The lines may be arranged to route electrical signals in a direction of a plane that is substantially parallel with a surface of the support 402 upon which the device region 428 is formed. For example, the lines may route electrical signals in a direction in and out of the page from the perspective of FIG. 5A. The vias may be arranged to route electrical signals in a direction of a plane that is substantially perpendicular to the surface of the support 402 upon which the device region 428 is formed. In some embodiments, the vias may electrically couple lines of different interconnect layers of the metallization stack together.

The interconnect layers 415 and 416 may include a dielectric material disposed between the interconnect structures 454. In some embodiments, the dielectric material disposed between the interconnect structures 454 in different ones of the interconnect layers 415 and 416 may have different compositions; in other embodiments, the composition of the dielectric material between different interconnect layers 415 and 416 may be the same.

A first interconnect layer 415 may be formed above the device region 428. The lines and/or the vias of the first interconnect layer 415 may be coupled with contacts (e.g., gate contacts 496 and/or S/D contact structures 494 of the IC structure 405) of the device region 428. In some embodiments, the first interconnect layer 415 includes a conductive element 452 at least partially over the S/D contact structure 494-1 and at least partially over the conductive via 426 to electrically couple the S/D contact structure 494-1 with the conductive via 426 at a first side 445 of the IC structure 405. The conductive element 452 includes an electrically conductive material, such as metal, and may have the same material composition or a different material composition than other electrically conductive elements of the IC structure 405, such as the interconnect structures 454. In one example, the conductive element 452 is or includes a conductive line or other conductive interconnect that couples the S/D contact structure 494-1 with the conductive via 426 (e.g., in a plane substantially parallel to the support 402). In one such example, the S/D region 459-1 is a source region of a transistor and the conductive via is a power via to deliver power to the source region 459-1 of the transistor.

A second interconnect layer 416 may be formed above the first interconnect layer 415. In some embodiments, the second interconnect layer 416 may include vias to couple the lines of the second interconnect layer 416 with the lines of the first interconnect layer 415. Additional interconnect layers, as desired, may be formed in succession on the second interconnect layer 416 according to similar techniques and configurations described in connection with the second interconnect layer 416 or the first interconnect layer 415. In some embodiments, the interconnect layers that are "higher up" in the metallization stack in the IC structure 405 (i.e., farther away from the device region 428) may be thicker. Although not specifically shown in FIG. 5, in some embodiments, the IC structure 405 may further include a solder resist material (e.g., polyimide or similar material) and one or more conductive contacts formed on the interconnect layers of the metallization stack.

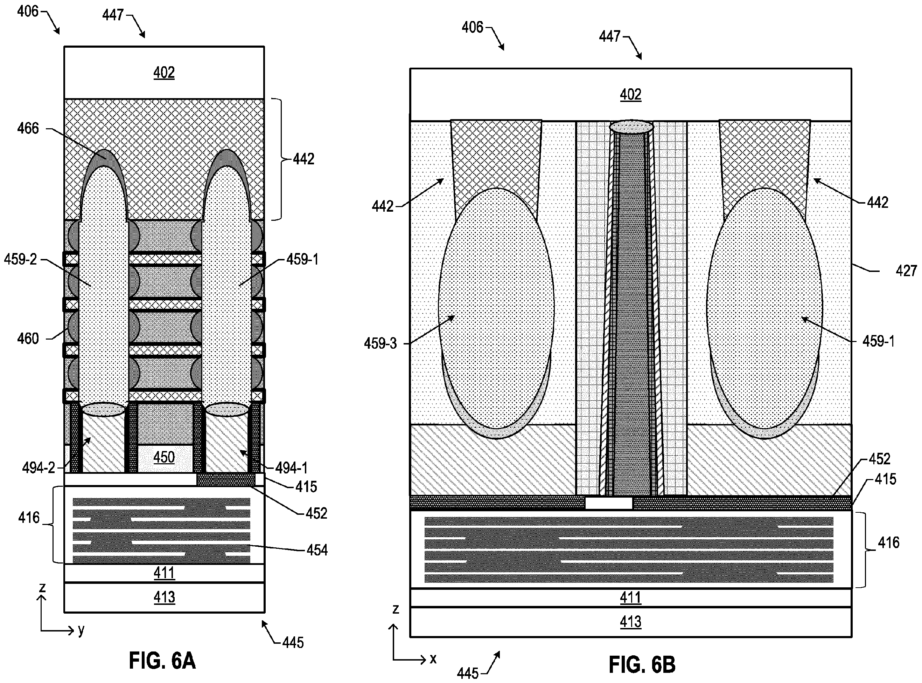

Referring again to FIG. 3, the method 300 continues with the process 306 of flipping over the preliminary IC structure. An IC structure 406 of FIGS. 6A-6B illustrates an example result of the process 306. In one example, in order to flip over the preliminary IC structure 405 of FIG. 5, a carrier substrate 413 is attached to the preliminary IC structure 405 of FIG. 5 using a bonding layer 411. As can be seen in FIG. 6, the preliminary IC structure 406 includes the carrier substrate 413 and bonding layer 411 on a first side 445 of the IC structure 406, and the IC structure 406 has been flipped upside down to enable processing from the second side 447 of the IC structure 406. The bonding layer 411 may include one or more bonding materials that can affix the carrier substrate 413 onto the preliminary IC structure 406. The carrier substrate 413 may facilitate the rest of the processing on the second side 447 of the IC structure 406.

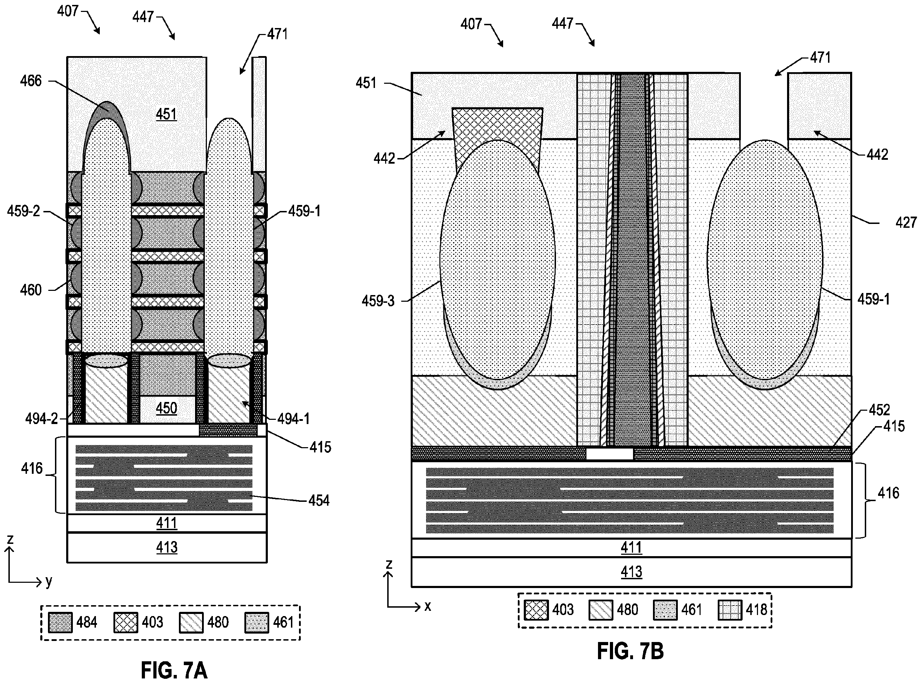

Referring again to FIG. 3, the method 300 continues with the process 308 of forming an opening over the region to expose the first semiconductor material in the opening. An IC structure 407 of FIGS. 7A-7B illustrates an example result of the process 308. As can be seen in FIG. 7, the IC structure 407 includes an opening 471 over the S/D region 459-1, which exposes the S/D material 470 at a bottom of the S/D region 459-1 from the second side 447. In one example, prior to forming the opening 471, one or more layers (such as the support 402) may be removed from the second side 447, e.g., through etch, polish, other processes, or some combination thereof. In one example, the semiconductor material 403 (e.g., the layer of semiconductor material 403 that was under the stack 478 of nanoribbons as shown in FIG. 5) may be removed and replaced with an insulator material 451. The insulator material 451 may be, for example, silicon oxide or another suitable insulator material. In other examples, the semiconductor material 403 may not be replaced by an insulator material.

Referring again to FIG. 7, in one example, forming the opening 471 involves etching the insulator material 451 over the S/D region 459-1. Etching the insulator material 451 may involve, for example, any suitable patterning techniques, such as, but not limited to, photolithographic or electron-beam (e-beam) patterning, possibly in conjunction with a suitable etching technique, e.g., a dry etch, such as e.g., RF reactive ion etch (RIE) or inductively coupled plasma (ICP) RIE. In some embodiments, the etch performed to form the opening 471 may include an anisotropic etch, using etchants in a form of e.g., chemically active ionized gas (i.e., plasma) using e.g., bromine (Br) and chloride (Cl) based chemistries. In some embodiments, during the etch to form the opening 471, the IC structure 407 may be heated to elevated temperatures, e.g., to temperatures between about room temperature and 200 degrees Celsius, including all values and ranges therein, to promote that byproducts of the etch are made sufficiently volatile to be removed from the surface. In one example, the insulator material 466 at the bottom of the S/D region 459-1 is also removed (e.g., through etch and/or polish) to reveal the semiconductor material 470 in the opening 471.

In one example, forming the opening over the S/D region 459-1 involves only forming openings over N-type or P-type S/D regions. For example, the transistor of FIG. 7 may be one of many transistors on a wafer, including N-type transistors (e.g., NMOS transistors) that include an N-type S/D regions and a P-type channel region and P-type transistors (e.g., PMOS transistors) that include P-type S/D regions and an N-type channel region. In one such example, the process of forming the opening 471 involves providing a mask over the second side 447 of the IC structure 407 to cover either N-type or P-type S/D regions, and with openings over either a source region or a drain region of the other type.

Referring again to FIG. 3, the method 300 continues with the process 310 of providing a second semiconductor material over the first semiconductor material in the opening. An IC structure 408 of FIGS. 8A-8B illustrates an example result of the process 310. As can be seen in FIGS. 8A-8B, the IC structure 408 includes a second semiconductor material 417 over the semiconductor material 459-1. In the example illustrated in FIG. 8, the second semiconductor material 417 is provided at a "bottom" of the S/D region 459-1 and the first semiconductor material 470 is provided at a "top" of the S/D region 459-1. In one example, the second semiconductor material 417 is in a portion of the S/D region 459-1 that is closer to the tapered end or tapered portion of the conductive via 226 than a portion of the S/D region 459-1 with the first semiconductor material. For example, the conductive via 426 includes a first end 422 (e.g., the end of the conductive via 426 closer to the first side 445) with a first width and a second end 421 (e.g., the end of the conductive via 426 closer to the second side 447) with a second width that is narrower than the first width, where a width of the conductive via 426 is a dimension of the via in a plane substantially parallel to the interconnect layer 415. In one such example, the second semiconductor material 417 is closer to the second end 421 than to the first end 422 of the conductive via 426.

In some embodiments, the second semiconductor material 417 and the first semiconductor material 470 may have crystal structures. For example, the first semiconductor material 470 or the second semiconductor material 417 may be formed through an epitaxial growth process, in which a crystal material may be formed with one or more well-defined orientations with respect to a crystal substrate after the material is deposited onto the crystal substrate. In one such example, the first semiconductor material 470 or the second semiconductor material 417 of the S/D region 459-1 may be referred to as semiconductor structures, epitaxial structures, or epitaxial semiconductor structures. In one example, the crystal substrate used for epitaxial growth may be a die or wafer or other layer suitable for epitaxial growth. The crystal direction of the epitaxial structures may be determined based on a crystal direction in the crystal substrate.

The second semiconductor material 417 may have one or more different properties from the first semiconductor material 470. For instance, the second semiconductor material 417 may be formed by depositing a different semiconductor material or using a different precursor for the deposition from the first semiconductor material 470. The second semiconductor material 417 may have one or more different chemical compounds from the first semiconductor material 470. Additionally, or alternatively, the second semiconductor material 417 and the first semiconductor material 470 may have different crystal directions (or crystallographic directions). For example, the first semiconductor material 470 may have a first crystal direction and the second semiconductor material 417 may have a different crystal direction that is different from the first crystal direction. The crystal direction of a crystal structure may be an orientation orthogonal to a lattice plane of the crystal structure. A lattice plane may be a plane whose intersections with the lattice are periodic, e.g., a plane of a surface of a unit crystal cell. The crystal direction of a crystal structure may be represented by Miller indices, such as [100], [010], [001], [110], [111], and so on. In some embodiments, the second semiconductor material 417 may be formed through a low-temperature epitaxial growth process. For instance, the second semiconductor material 417 may be deposited at a relatively low temperature. The second semiconductor material 417 may be formed through epitaxial growth of the second semiconductor material 417. One or more precursors may be used for facilitating the epitaxial growth. In some embodiments, the temperature of the epitaxial growth may be below approximately 400 °C. In one such example, the temperature at which the second semiconductor material 417 is formed is lower compared with the temperature at which the first semiconductor material 470 is formed. For instance, the first semiconductor material 470 may be formed at a temperature above approximately 500 °C, e.g., temperatures in a range from approximately 500 °C to approximately 600 °C. The lower-temperature epitaxial growth can avoid damage to the other components in the preliminary IC structure 408.

The lower-temperature epitaxial growth to grow the second semiconductor material 417 may use different precursors from the high-temperature epitaxial growth used to grow the first semiconductor material 470. Examples of precursors for the lower-temperature epitaxial growth may include high order precursors, such as Si₂H₆ and Ge₂H₆. Examples of precursors for the lower-temperature epitaxial growth may include SiH4, GeH4, Dichlorosilane (DSC, H₂SiCl₂), hydrochloric acid (HCl), and so on. Given the usage of different precursors in the epitaxial growth processes, the second semiconductor material 417 may have a different material composition than the first semiconductor material 470. In some embodiments, the second semiconductor material 417 may be formed after a surface treatment process that treats the surfaces on which the second semiconductor material 417 is to be provided. The surface treatment process may include physical treatment or chemical treatment. The surface treatment process may clean the surfaces, change one or more chemical compounds at the surfaces, or change the surface in other manners to get the surface ready for epitaxial growth. In one example, the first semiconductor material 470 and the second semiconductor material 417 may include the same elements, but at different percentages. In one such example, the first semiconductor material 470 and the second semiconductor material 417 both include boron and germanium, but one of the semiconductor materials 470, 417 (e.g., the second semiconductor material 417) may have a higher percentage germanium and/or a higher boron activation percentage. Thus, according to examples, the first semiconductor material 470 may have one or more different material properties than the second semiconductor material 417, such as a different material composition and/or a different crystal direction.

In the example illustrated in FIG. 8, the volume of the first semiconductor material 470 of the S/D region 459-1 is greater than the volume of the second semiconductor material 417. Depending on the implementation, various ratios of the first semiconductor material 470 to the second semiconductor material 417 are possible. In some examples, 50-97% of the S/D region 459-1 includes the first semiconductor material 470 and the remaining percentage (e.g., 3-50% of the S/D region 459-1) includes the second semiconductor material 417. In other examples, the percentage of the S/D region 459-1 that includes the first semiconductor material 470 is less than 50% or more than 97%. According to some examples, the dimensions of the first semiconductor material 470 and the second semiconductor material 417 of the S/D region 459-1 may also be different. For example, the height and/or width of the first semiconductor material 470 may be greater than the height and/or width of the second semiconductor material 417, where the height of the first or second semiconductor materials 470, 417 is a dimension of the material of the S/D region in a plane substantially perpendicular to the interconnect layer 415, e.g., along the z-axis, and the width of the first or second semiconductor materials 470, 417 is a dimension of the material of the S/D region in a plane substantially parallel to the interconnect layer 415, e.g., along the y-axis.

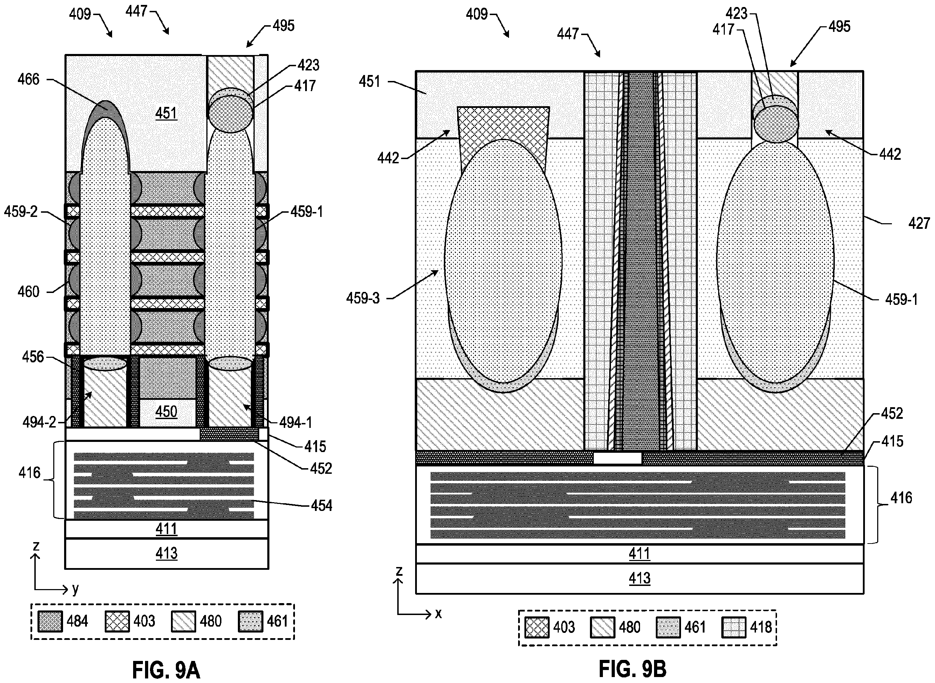

Referring again to FIG. 3, the method 300 continues with the process 312 of providing a second contact structure over the second semiconductor material. An IC structure 409 of FIGS. 9A-9B illustrates an example result of the process 312. As can be seen in FIGS. 9A-9B, the IC structure 409 includes an S/D contact structure 495 over the second semiconductor material 417. The S/D contact structure 495 is provided at the second side 447, and therefore may be referred to as a "back-side S/D contact" or "back-side S/D contact structure." The S/D contact structure 495 includes an electrically conductive fill material 480. Although the front-side S/D contact structures 494 and the back-side S/D contact structure 495 are depicted as including the same conductive material 480, in other examples, the conductive material of the back-side S/D contact structure 495 may be different from the conductive material 480 of the front-side S/D contact structures 494. In one example, an interface material 423 is formed over the second semiconductor material 417 prior to providing the S/D contact structure 494. In one such example, the interface material may be the same as the interface material 461 between the first semiconductor material 470 and the conductive material 480 of the front-side S/D contact structure 494.

According to examples, the back-side S/D contact structure 495 may include one or more different properties from the front-side contacts 494. In the example illustrated in FIG. 9, the IC structure 409 includes a liner 456 including a liner material on sidewalls of the S/D contact structure structures 494, and lacks a liner including the liner material on sidewalls of the S/D contact structure 495 (although there may be a liner including a different liner material on sidewalls of the S/D contact structure 495). In other examples, one or more liners may be present between the conductive material 480 of the contact structure 495 and the insulator material 451, including a liner having the same liner material as the liner 456. After providing the back-side contact structure 495, the conductive via 426 can be coupled with the S/D region 459-1 from the second side 447 of the IC structure 409 in addition to the first side 445 of the IC structure 409.

Referring again to FIG. 3, the method 300 continues with the process 314 of providing a second conductive element at least partially over the second contact structure and at least partially over the conductive via. An IC structure 410 of FIGS. 10A-10B illustrates an example result of the process 314. As can be seen in FIGS. 10A-10B, the IC structure 410 includes a conductive element 483 at least partially over the back-side contact structure 495 and at least partially over the conductive via 426. The conductive element 483 includes an electrically conductive material, such as metal, and may have the same material composition or a different material composition than other electrically conductive elements of the IC structure 410, such as the interconnect structures 454 and/or the conductive element 452. In one example, the conductive element 452 is or includes a conductive line or another conductive interconnect that couples the S/D contact structure 494-1 with the conductive via 426 (e.g., in a plane substantially parallel to the support 402) from the back side (e.g., the second side 447) of the IC structure 410. In one example, the conductive element 483 is included in an interconnect layer 497 over the second side 447 of the IC structure. One or more additional interconnect layers may be formed over the interconnect layer 497 including the conductive element 483.

Performing the method 300 may result in features in the final IC structures that are characteristic of the use of the method 300. For example, one such feature is illustrated in the IC structure 410 shown in FIG. 10, which shows a conductive via 426 extending between a first layer (e.g., the interconnect layer 415) and a second layer (e.g., the interconnect layer 497) and a region (e.g., the S/D region 459-1) between the first layer and the second layer that is either a source region or a drain region of a transistor. The S/D region 459-1 includes a first portion 493-1 including a first semiconductor material 470 and a second portion 493-2 including a second semiconductor material 417. A first conductive element (e.g., the conductive element 452) in the first layer is coupled with the conductive via 426 and the first portion 493-1 of the S/D region 459-1 and a second conductive element 483 in the second layer is coupled with the conductive via 426 and the second portion 493-2 of the S/D region 495-1. The connections at both ends of the S/D region 459-1 and both ends of the conductive via 426 enable an additional current path compared to IC structures in which the conductive via is only coupled with the S/D region from the front side.

Thus, IC structures including a conductive via connected with front-side and back-side contacts of an S/D region as described herein can decrease resistance in the conductive via by increasing the contact surface with the S/D contact structures. Additionally, the back-side epitaxial regrowth of the second semiconductor material at the bottom of the S/D region can improve yield issues resulting from gaps in the first semiconductor material in the bottom of the S/D regions (e.g., gaps caused by defects or side effects of one or more processes performed to form the IC structure).

IC devices/structures that include conductive vias coupled with an S/D region with both front-side and back-side contacts as described herein (e.g., as described with reference to FIGS. 3-10) may be used to implement any suitable components. For example, in various embodiments, IC structures described herein may be part of one or more of: a central processing unit, a memory device (e.g., a high-bandwidth memory device), a memory cell, a logic circuit, input/output circuitry, a field programmable gate array (FPGA) component such as an FPGA transceiver or an FPGA logic, a power delivery circuitry, an amplifier (e.g., a III-V amplifier), Peripheral Component Interconnect Express (PCIE) circuitry, Double Data Rate (DDR) transfer circuitry, a computing device (e.g., a wearable or a handheld computing device), etc.

The IC devices and structures disclosed herein, e.g., the IC structures 100, 200, and 404-410, or any variations thereof, may be included in any suitable electronic component.

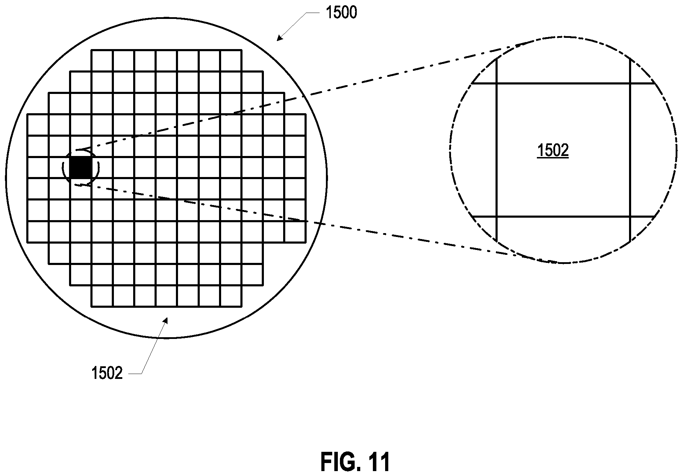

FIGS. 11-14 illustrate various examples of apparatuses that may include any of the IC devices/structures disclosed herein.

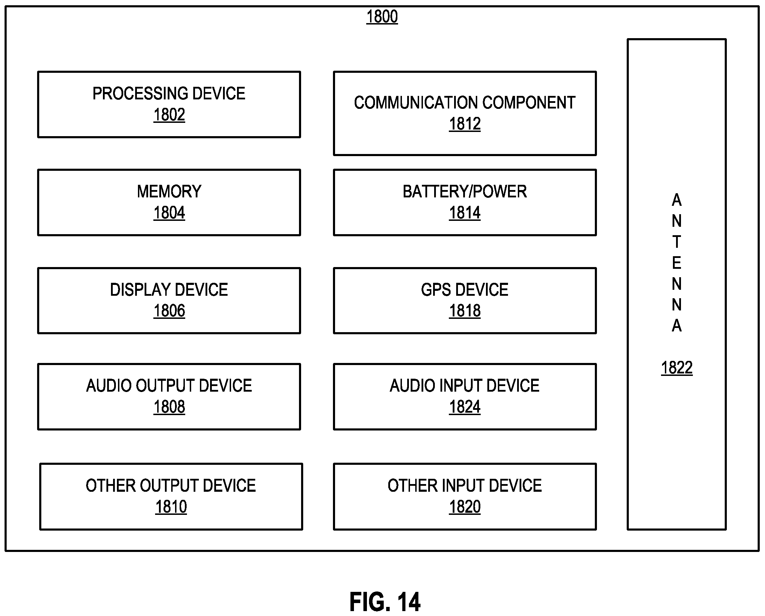

FIG. 11 is a top view of a wafer 1500 and dies 1502 that may include one or more IC structures in accordance with any of the embodiments disclosed herein. The wafer 1500 may be composed of semiconductor material and may include one or more dies 1502 having IC structures formed on a surface of the wafer 1500. Each of the dies 1502 may be a repeating unit of a semiconductor product that includes any suitable IC. After the fabrication of the semiconductor product is complete, the wafer 1500 may undergo a singulation process in which the dies 1502 are separated from one another to provide discrete "chips" of the semiconductor product. The die 1502 may include one or more IC structures as described herein (e.g., any of the IC structures 100, 200, and 404-410, described herein), one or more transistors (e.g., nanoribbon transistors of the IC structures 100, 200, and 404-410) and/or supporting circuitry to route electrical signals to the transistors, as well as any other IC components. In some embodiments, the wafer 1500 or the die 1502 may include a memory device (e.g., a random-access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuit element. Multiple ones of these devices may be combined on a single die 1502. For example, a memory array formed by multiple memory devices may be formed on a same die 1502 as a processing device (e.g., the processing device 1802 of FIG. 14) or other logic that is configured to store information in the memory devices or execute instructions stored in the memory array.

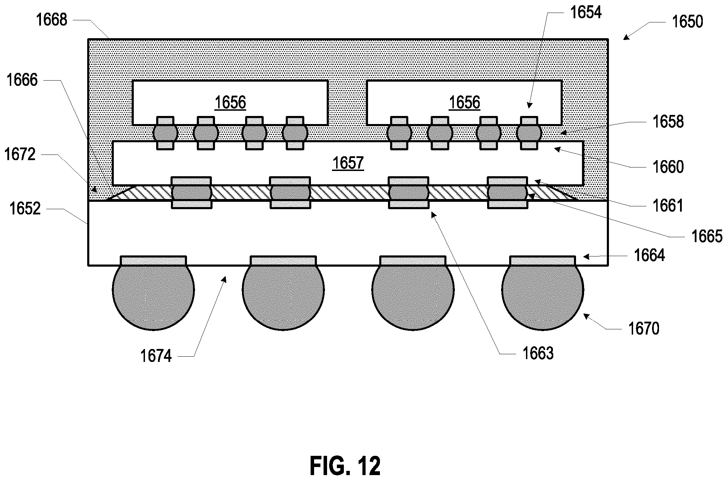

FIG. 12 is a side, cross-sectional view of an example IC package 1650 that may include one or more IC structures in accordance with any of the embodiments disclosed herein (e.g., any of the IC structures 100, 200, and 404-410, described herein). In some embodiments, the IC package 1650 may be a system-in-package (SiP).

The package substrate 1652 may be formed of a dielectric material (e.g., a ceramic, a buildup film, an epoxy film having filler particles therein, glass, an organic material, an inorganic material, combinations of organic and inorganic materials, embedded portions formed of different materials, etc.), and may have conductive pathways extending through the dielectric material between the face 1672 and the face 1674, or between different locations on the face 1672, and/or between different locations on the face 1674. These conductive pathways may take the form of any of the interconnects discussed above with reference to FIG. 5.

The package substrate 1652 may include conductive contacts 1663 that are coupled to conductive pathways (not shown) through the package substrate 1652, allowing circuitry within the dies 1656 and/or the interposer 1657 to electrically couple to various ones of the conductive contacts 1664 (or to devices included in the package substrate 1652, not shown).

The IC package 1650 may include an interposer 1657 coupled to the package substrate 1652 via conductive contacts 1661 of the interposer 1657, first-level interconnects 1665, and the conductive contacts 1663 of the package substrate 1652. The first-level interconnects 1665 illustrated in FIG. 6 are solder bumps, but any suitable first-level interconnects 1665 may be used. In some embodiments, no interposer 1657 may be included in the IC package 1650; instead, the dies 1656 may be coupled directly to the conductive contacts 1663 at the face 1672 by first-level interconnects 1665. More generally, one or more dies 1656 may be coupled to the package substrate 1652 via any suitable structure (e.g., a silicon bridge, an organic bridge, one or more waveguides, one or more interposers, wirebonds, etc.).

The IC package 1650 may include one or more dies 1656 coupled to the interposer 1657 via conductive contacts 1654 of the dies 1656, first-level interconnects 1658, and conductive contacts 1660 of the interposer 1657. The conductive contacts 1660 may be coupled to conductive pathways (not shown) through the interposer 1657, allowing circuitry within the dies 1656 to electrically couple to various ones of the conductive contacts 1661 (or to other devices included in the interposer 1657, not shown). The first-level interconnects 1658 illustrated in FIG. 6 are solder bumps, but any suitable first-level interconnects 1658 may be used. As used herein, a "conductive contact" may refer to a portion of conductive material (e.g., metal) serving as an interface between different components; conductive contacts may be recessed in, flush with, or extending away from a surface of a component, and may take any suitable form (e.g., a conductive pad or socket).

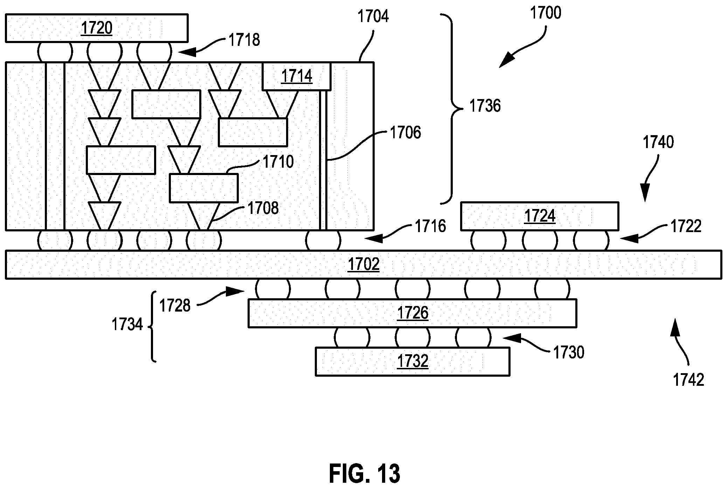

In some embodiments, an underfill material 1666 may be disposed between the package substrate 1652 and the interposer 1657 around the first-level interconnects 1665, and a mold compound 1668 may be disposed around the dies 1656 and the interposer 1657 and in contact with the package substrate 1652. In some embodiments, the underfill material 1666 may be the same as the mold compound 1668. Example materials that may be used for the underfill material 1666 and the mold compound 1668 are epoxy mold materials, as suitable. Second-level interconnects 1670 may be coupled to the conductive contacts 1664. The second-level interconnects 1670 illustrated in FIG. 12 are solder balls (e.g., for a ball grid array arrangement), but any suitable second-level interconnects 1670 may be used (e.g., pins in a pin grid array arrangement or lands in a land grid array arrangement). The second-level interconnects 1670 may be used to couple the IC package 1650 to another component, such as a circuit board (e.g., a motherboard), an interposer, or another IC package, as known in the art and as discussed below with reference to FIG. 13.

The dies 1656 may take the form of any of the embodiments of the die 1502 discussed herein. In embodiments in which the IC package 1650 includes multiple dies 1656, the IC package 1650 may be referred to as a multi-chip package (MCP). The dies 1656 may include circuitry to perform any desired functionality. For example, or more of the dies 1656 may be logic dies (e.g., silicon-based dies), and one or more of the dies 1656 may be memory dies (e.g., high-bandwidth memory).

Although the IC package 1650 illustrated in FIG. 12 is a flip chip package, other package architectures may be used. For example, the IC package 1650 may be a ball grid array (BGA) package, such as an embedded wafer-level ball grid array (eWLB) package. In another example, the IC package 1650 may be a wafer-level chip scale package (WLCSP) or a panel fanout (FO) package. Although two dies 1656 are illustrated in the IC package 1650 of FIG. 12, an IC package 1650 may include any desired number of dies 1656. An IC package 1650 may include additional passive components, such as surface-mount resistors, capacitors, and inductors disposed on the first face 1672 or the second face 1674 of the package substrate 1652, or on either face of the interposer 1657. More generally, an IC package 1650 may include any other active or passive components known in the art.

FIG. 13 is a side, cross-sectional view of an IC device assembly 1700 that may include one or more IC packages or other electronic components (e.g., a die) including one or more IC devices in accordance with any of the embodiments disclosed herein. The IC device assembly 1700 includes a number of components disposed on a circuit board 1702 (which may be, e.g., a motherboard). The IC device assembly 1700 includes components disposed on a first face 1740 of the circuit board 1702 and an opposing second face 1742 of the circuit board 1702; generally, components may be disposed on one or both faces 1740 and 1742. Any of the IC packages discussed below with reference to the IC device assembly 1700 may take the form of any of the embodiments of the IC package 1650 discussed above with reference to FIG. 12 (e.g., may include one or more the IC structures 100, 200, and 404-410).

In some embodiments, the circuit board 1702 may be a PCB including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 1702. In other embodiments, the circuit board 1702 may be a non-PCB substrate.

The IC device assembly 1700 illustrated in FIG. 13 includes a package-on-interposer structure 1736 coupled to the first face 1740 of the circuit board 1702 by coupling components 1716. The coupling components 1716 may electrically and mechanically couple the package-on-interposer structure 1736 to the circuit board 1702, and may include solder balls (as shown in FIG. 13), male and female portions of a socket, an adhesive, an underfill material, and/or any other suitable electrical and/or mechanical coupling structure.

The package-on-interposer structure 1736 may include an IC package 1720 coupled to a package interposer 1704 by coupling components 1718. The coupling components 1718 may take any suitable form for the application, such as the forms discussed above with reference to the coupling components 1716. Although a single IC package 1720 is shown in FIG. 13, multiple IC packages may be coupled to the package interposer 1704; indeed, additional interposers may be coupled to the package interposer 1704. The package interposer 1704 may provide an intervening substrate used to bridge the circuit board 1702 and the IC package 1720. The IC package 1720 may be or include, for example, a die (the die 1502 of FIG. 11), an IC device (e.g., any of the IC structures 100, 200, and 404-410, described herein, or any combination of such IC devices), or any other suitable component. Generally, the package interposer 1704 may spread a connection to a wider pitch or reroute a connection to a different connection. For example, the package interposer 1704 may couple the IC package 1720 (e.g., a die) to a set of BGA conductive contacts of the coupling components 1716 for coupling to the circuit board 1702. In the embodiment illustrated in FIG. 13, the IC package 1720 and the circuit board 1702 are attached to opposing sides of the package interposer 1704; in other embodiments, the IC package 1720 and the circuit board 1702 may be attached to a same side of the package interposer 1704. In some embodiments, three or more components may be interconnected by way of the package interposer 1704.

In some embodiments, the package interposer 1704 may be formed as a PCB, including multiple metal layers separated from one another by layers of dielectric material and interconnected by electrically conductive vias. In some embodiments, the package interposer 1704 may be formed of an epoxy resin, a fiberglass-reinforced epoxy resin, an epoxy resin with inorganic fillers, a ceramic material, or a polymer material such as polyimide. In some embodiments, the package interposer 1704 may be formed of alternate rigid or flexible materials that may include the same materials described above for use in a semiconductor substrate, such as silicon, germanium, and other group III-V and group IV materials. The package interposer 1704 may include metal lines 1710 and vias 1708, including but not limited to through-silicon vias (TSVs) 1706. The package interposer 1704 may further include embedded devices 1714, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as RF devices, power amplifiers, power management devices, antennas, arrays, sensors, and microelectromechanical systems (MEMS) devices may also be formed on the package interposer 1704. The package-on-interposer structure 1736 may take the form of any of the package-on-interposer structures known in the art.

The IC device assembly 1700 may include an IC package 1724 coupled to the first face 1740 of the circuit board 1702 by coupling components 1722. The coupling components 1722 may take the form of any of the embodiments discussed above with reference to the coupling components 1716, and the IC package 1724 may take the form of any of the embodiments discussed above with reference to the IC package 1720.

The IC device assembly 1700 illustrated in FIG. 13 includes a package-on-package structure 1734 coupled to the second face 1742 of the circuit board 1702 by coupling components 1728. The package-on-package structure 1734 may include an IC package 1726 and an IC package 1732 coupled together by coupling components 1730 such that the IC package 1726 is disposed between the circuit board 1702 and the IC package 1732. The coupling components 1728 and 1730 may take the form of any of the embodiments of the coupling components 1716 discussed above, and the IC packages 1726 and 1732 may take the form of any of the embodiments of the IC package 1720 discussed above. The package-on-package structure 1734 may be configured in accordance with any of the package-on-package structures known in the art.

FIG. 14 is a block diagram of an example electrical device 1800 that may include one or more IC structures 100 in accordance with any of the embodiments disclosed herein. For example, any suitable ones of the components of the electrical device 1800 may include one or more of the IC device assemblies 1700, IC packages 1650, or dies 1502 disclosed herein. A number of components are illustrated in FIG. 14 as included in the electrical device 1800, but any one or more of these components may be omitted or duplicated, as suitable for the application. In some embodiments, some or all of the components included in the electrical device 1800 may be attached to one or more motherboards. In some embodiments, some or all of these components are fabricated onto a single system-on-a-chip (SoC) die.

Additionally, in various embodiments, the electrical device 1800 may not include one or more of the components illustrated in FIG. 14, but the electrical device 1800 may include interface circuitry for coupling to the one or more components. For example, the electrical device 1800 may not include a display device 1806, but may include display device interface circuitry (e.g., a connector and driver circuitry) to which a display device 1806 may be coupled. In another set of examples, the electrical device 1800 may not include an audio input device 1824 or an audio output device 1808, but may include audio input or output device interface circuitry (e.g., connectors and supporting circuitry) to which an audio input device 1824 or audio output device 1808 may be coupled.

The electrical device 1800 may include a processing device 1802 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 1802 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices. The electrical device 1800 may include a memory 1804, which may itself include one or more memory devices such as volatile memory (e.g., dynamic RAM (DRAM)), nonvolatile memory (e.g., read-only memory (ROM)), flash memory, solid state memory, and/or a hard drive. In some embodiments, the memory 1804 may include memory that shares a die with the processing device 1802. This memory may be used as cache memory and may include embedded dynamic RAM (eDRAM) or spin transfer torque magnetic RAM (STT-MRAM).

In some embodiments, the electrical device 1800 may include a communication chip 1812 (e.g., one or more communication chips). For example, the communication chip 1812 may be configured for managing wireless communications for the transfer of data to and from the electrical device 1800. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

The communication chip 1812 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 1812 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 1812 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 1812 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 1812 may operate in accordance with other wireless protocols in other embodiments. The electrical device 1800 may include an antenna 1822 to facilitate wireless communications and/or to receive other wireless communications (such as AM or FM radio transmissions).

In some embodiments, the communication chip 1812 may manage wired communications, such as electrical, optical, or any other suitable communication protocols (e.g., the Ethernet). As noted above, the communication chip 1812 may include multiple communication chips. For instance, a first communication chip 1812 may be dedicated to shorter-range wireless communications such as Wi-Fi or Bluetooth, and a second communication chip 1812 may be dedicated to longer-range wireless communications such as global positioning system (GPS), EDGE, GPRS, CDMA, WiMAX, LTE, EV-DO, or others. In some embodiments, a first communication chip 1812 may be dedicated to wireless communications, and a second communication chip 1812 may be dedicated to wired communications.

The electrical device 1800 may include battery/power circuitry 1814. The battery/power circuitry 1814 may include one or more energy storage devices (e.g., batteries or capacitors) and/or circuitry for coupling components of the electrical device 1800 to an energy source separate from the electrical device 1800 (e.g., AC line power).

The electrical device 1800 may include a display device 1806 (or corresponding interface circuitry, as discussed above). The display device 1806 may include any visual indicators, such as a heads-up display, a computer monitor, a projector, a touchscreen display, a liquid crystal display (LCD), a light-emitting diode display, or a flat panel display.

The electrical device 1800 may include an audio output device 1808 (or corresponding interface circuitry, as discussed above). The audio output device 1808 may include any device that generates an audible indicator, such as speakers, headsets, or earbuds.

The electrical device 1800 may include an audio input device 1824 (or corresponding interface circuitry, as discussed above). The audio input device 1824 may include any device that generates a signal representative of a sound, such as microphones, microphone arrays, or digital instruments (e.g., instruments having a musical instrument digital interface (MIDI) output).

The electrical device 1800 may include a GPS device 1818 (or corresponding interface circuitry, as discussed above). The GPS device 1818 may be in communication with a satellite-based system and may receive a location of the electrical device 1800, as known in the art.

The electrical device 1800 may include an other output device 1810 (or corresponding interface circuitry, as discussed above). Examples of the other output device 1810 may include an audio codec, a video codec, a printer, a wired or wireless transmitter for providing information to other devices, or an additional storage device.

The electrical device 1800 may include an other input device 1820 (or corresponding interface circuitry, as discussed above). Examples of the other input device 1820 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The electrical device 1800 may have any desired form factor, such as a handheld or mobile electrical device (e.g., a cell phone, a smart phone, a mobile internet device, a music player, a tablet computer, a laptop computer, a netbook computer, an ultrabook computer, a personal digital assistant (PDA), an ultra mobile personal computer, etc.), a desktop electrical device, a server device or other networked computing component, a printer, a scanner, a monitor, a set-top box, an entertainment control unit, a vehicle control unit, a digital camera, a digital video recorder, or a wearable electrical device. In some embodiments, the electrical device 1800 may be any other electronic device that processes data.

The following paragraphs provide various examples of the embodiments disclosed herein.

Example 1 provides an IC structure, including a conductive via between a first layer and a second layer and a region between the first layer and the second layer, where the region is either a source region or a drain region of a transistor, and where the region includes a first portion including a first semiconductor material and a second portion including a second semiconductor material. The IC structure further includes a first conductive element in the first layer coupled with the conductive via and the first portion of the region, and a second conductive element in the second layer coupled with the conductive via and the second portion of the region.

Example 2 provides the IC structure of example 1, where: the first semiconductor material has a first crystal direction, and the second semiconductor material has a second crystal direction that is different from the first crystal direction.

Example 3 provides the IC structure of example 1 or 2, where: the first semiconductor material has a different material composition from the second semiconductor material.

Example 4 provides the IC structure of any one of examples 1-3, where: the region includes a greater volume of the first semiconductor material than of the second semiconductor material.

Example 5 provides the IC structure of any one of examples 1-4, further including a first contact structure between the first portion of the region and the first conductive element, and a second contact structure between the second portion of the region and the second conductive element.

Example 6 provides the IC structure of example 5, where: the first contact structure includes a liner including a liner material on sidewalls of the first contact structure, and the second contact structure lacks a liner including the liner material on sidewalls of the second contact structure.

Example 7 provides the IC structure of example 5 or 6, where: the second contact structure includes an electrically conductive material, and the IC structure further includes an interface material between the second semiconductor material and the electrically conductive material.

Example 8 provides the IC structure of any one of examples 1-7, where: the conductive via includes a first end with a first width and a second end with a second width that is narrower than the first width, and where the second semiconductor material is closer to the second end than to the first end.

Example 9 provides an IC structure, including a first layer including a first conductive interconnect, a second layer over the first layer, where the second layer includes a second conductive interconnect, and a third layer between the first layer and the second layer, where the third layer includes a conductive via having a first end coupled with the first conductive interconnect and a second end coupled with the second conductive interconnect, and a region including semiconductor materials with a dopant concentration of at least 10²¹ dopants per cubic centimeter. The region includes a first portion including a first semiconductor material coupled with the first conductive interconnect, and a second portion including a second semiconductor material coupled with the second conductive interconnect.

Example 10 provides the IC structure of example 9, where: a crystal direction of the first semiconductor material is different from a crystal direction of the second semiconductor material.

Example 11 provides the IC structure of example 9 or 10, where: the first semiconductor material has one or more different chemical compounds from the second semiconductor material.

Example 12 provides the IC structure of any one of examples 9-11, where: a first volume of the first semiconductor material in the first portion is greater than a second volume of the second semiconductor material in the second portion.

Example 13 provides the IC structure of any one of examples 9-12, further including a first contact structure coupled with the first portion of the region and coupled with the first conductive interconnect and a second contact structure coupled with the second portion of the region and coupled with the second conductive interconnect.

Example 14 provides the IC structure of example 13, where: the second contact structure includes an electrically conductive material, and the IC structure further includes an interface material between the second semiconductor material of the second portion and the electrically conductive material.

Example 15 provides the IC structure of any one of examples 9-14, where: the second portion of the region is closer than the first portion of the region to a tapered portion of the conductive via.

Example 16 provides an integrated circuit structure, including a source region of a transistor, a conductive via in a same layer as the source region, a first contact structure coupled with the source region and coupled with the conductive via at a first side of the IC structure, and a second contact structure coupled with the source region and coupled with the conductive via at a second side of the IC structure, where the second side of the IC structure is opposite to the first side.

Example 17 provides the IC structure of example 16, where: the source region includes a first semiconductor structure and a second semiconductor structure, the first semiconductor structure includes a first semiconductor material, the second semiconductor structure includes a second semiconductor material, and the first semiconductor structure is closer than the second semiconductor structure to the first side of the IC structure.

Example 18 provides the IC structure of example 17, where: the first semiconductor material has one or more different material properties than the second semiconductor material, including: a different material composition and a different crystal direction.

Example 19 provides the IC structure of example 17 or 18, where: the source region includes a greater volume of the first semiconductor material than of the second semiconductor material.

Example 20 provides the IC structure of any one of examples 17-19, further including a first contact structure coupled with the first semiconductor structure, a second contact structure coupled with the second semiconductor structure, a first conductive interconnect coupled with the first contact structure and the conductive via at the first side, and a second conductive interconnect coupled with the second contact structure and the conductive via at the second side.

Example 21 provides an IC structure according to any one of examples 1-20, where the IC structure includes or is a part of a central processing unit.

Example 22 provides an IC structure according to any one of examples 1-21, where the IC structure includes or is a part of a memory device.

Example 23 provides an IC structure according to any one of examples 1-22, where the IC structure includes or is a part of a logic circuit.

Example 24 provides an IC structure according to any one of examples 1-23, where the IC structure includes or is a part of input/output circuitry.

Example 25 provides an IC structure according to any one of examples 1-24, where the IC structure includes or is a part of a field programmable gate array transceiver.

Example 26 provides an IC structure according to any one of examples 1-25, where the IC structure includes or is a part of a field programmable gate array logic.

Example 27 provides an IC structure according to any one of examples 1-26, where the IC structure includes or is a part of a power delivery circuitry.

Example 28 provides an IC package that includes an IC die including an IC structure according to any one of examples 1-27; and a further IC component, coupled to the IC die.

Example 29 provides an IC package according to example 28 where the further IC component includes a package substrate.

Example 30 provides an IC package according to example 28, where the further IC component includes an interposer.

Example 31 provides an IC package according to example 28, where the further IC component includes a further IC die.

Example 32 provides a computing device that includes a carrier substrate and an IC structure coupled to the carrier substrate, where the IC structure is an IC structure according to any one of examples 1-27, or the IC structure is included in the IC package according to any one of examples 28-30.

Example 33 provides a computing device according to example 32, where the computing device is a wearable or handheld computing device.

Example 34 provides a computing device according to examples 32 or 33, where the computing device further includes one or more communication chips.

Example 35 provides a computing device according to any one of examples 32-34, where the computing device further includes an antenna.

Example 36 provides a computing device according to any one of examples 32-35, where the carrier substrate is a motherboard.

Example 37 provides a method of fabricating an IC structure, the method including providing a preliminary IC structure, where the preliminary IC structure includes a region including a first semiconductor material, a first contact structure coupled with the region from a first side of the preliminary IC structure, and a conductive via in a same layer as the region. The method further includes providing a first conductive element at least partially over the first contact structure and at least partially over the conductive via; flipping over the preliminary IC structure to expose a second side of the preliminary IC structure; forming an opening over the region, where the first semiconductor material is exposed in the opening; providing a second semiconductor material over the first semiconductor material in the opening; providing a second contact structure over the second semiconductor material; and providing a second conductive element at least partially over the second contact structure and at least partially over the conductive via.

Example 38 provides the method of example 37, further including prior to forming the opening, removing a third semiconductor material from the second side of the preliminary IC structure; and providing an insulator material over the second side of the preliminary IC structure.

Example 39 provides the method of examples 37 or 38, where: providing the second semiconductor material includes epitaxially growing the second semiconductor material over the first semiconductor material in the opening.

Example 40 provides the method of any one of examples 37-39, further including forming a layer of an interface material over the second semiconductor material.

Example 41 provides a method according to any one of examples 37-40, where the IC structure is an IC structure according to any one of the preceding examples.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize. These modifications may be made to the disclosure in light of the above detailed description.

## Claims

1. An integrated circuit (IC) structure, comprising:
a conductive via (426) between a first layer and a second layer;
a region (459-1) between the first layer and the second layer, wherein the region is either a source region or a drain region of a transistor, and wherein the region includes a first portion including a first semiconductor material (470) and a second portion including a second semiconductor material (417);
a first conductive element (452) in the first layer coupled with the conductive via and the first portion of the region; and
a second conductive element (483) in the second layer coupled with the conductive via and the second portion of the region.

2. The IC structure of claim 1, wherein:
the first semiconductor material has a first crystal direction; and
the second semiconductor material has a second crystal direction that is different from the first crystal direction.

3. The IC structure of claims 1 or 2, wherein:
the first semiconductor material has a different material composition from the second semiconductor material.

4. The IC structure of any one of claims 1-3, wherein:
the first semiconductor material and the second semiconductor material include different percentages of one or more elements.

5. The IC structure of any one of claims 1-4, wherein:
the first semiconductor material and the second semiconductor material include one or more different chemical compounds.

6. The IC structure of any one of claims 1-5, wherein:
the region includes a greater volume of the first semiconductor material than of the second semiconductor material.

7. The IC structure of claim 6, wherein:
about 50-97% of the region includes the first semiconductor material.

8. The IC structure of any one of claims 1-7, further comprising:
a first contact structure between the first portion of the region and the first conductive element; and
a second contact structure between the second portion of the region and the second conductive element.

9. The IC structure of claim 8, wherein:
the first contact structure includes a liner including a liner material on first sidewalls of the first contact structure; and
the second contact structure lacks the liner material on second sidewalls of the second contact structure.

10. The IC structure of claim 8, wherein:
the second contact structure includes an electrically conductive material; and
the IC structure further includes an interface material (423) between the second semiconductor material and the electrically conductive material.

11. The IC structure of any one of claims 1-10, wherein:
the conductive via includes a first end with a first width and a second end with a second width that is narrower than the first width; and
the second semiconductor material is closer to the second end than to the first end.

12. A method of fabricating an integrated circuit (IC) structure, the method comprising:
providing a preliminary IC structure, wherein the preliminary IC structure comprises:
a region comprising a first semiconductor material,
a first contact structure coupled with the region from a first side of the preliminary IC structure, and
a conductive via in a same layer as the region;
providing a first conductive element at least partially over the first contact structure and at least partially over the conductive via;
flipping over the preliminary IC structure to expose a second side of the preliminary IC structure;
forming an opening over the region, wherein the first semiconductor material is exposed in the opening;
providing a second semiconductor material over the first semiconductor material in the opening;
providing a second contact structure over the second semiconductor material; and
providing a second conductive element at least partially over the second contact structure and at least partially over the conductive via.

13. The method of claim 12, further comprising:
prior to forming the opening, removing a third semiconductor material from the second side of the preliminary IC structure; and
providing an insulator material over the second side of the preliminary IC structure.

14. The method of claims 12 or 13, wherein:
providing the second semiconductor material comprises:
epitaxially growing the second semiconductor material over the first semiconductor material in the opening.

15. The method of any one of claims 12-14, further comprising:
forming a layer of an interface material over the second semiconductor material.
